# EUROPEAN PATENT APPLICATION

(11) **EP 3 270 391 A1**
(43) Date of publication of application: **17.01.2018**
(21) Application number: 16761479.1
(22) Date of filing: 23.02.2016
(51) Int. Cl.: H01G 9/20, C09B 57/10, C09B 67/44

(54) **PHOTOELECTRIC CONVERSION ELEMENT, DYE-SENSITIZED SOLAR CELL, METAL COMPLEX DYE, AND DYE SOLUTION**

(30) Priority: 09.03.2015 JP 2015046442
(71) Applicant: FUJIFILM Corporation, Tokyo 106-8620 (JP)
(72) Inventor: TSUNA, Kazuhiro, Ashigarakami-gun Kanagawa 258-8577 (JP); WATANABE, Kousuke, Ashigarakami-gun Kanagawa 258-8577 (JP); KOBAYASHI, Katsumi, Ashigarakami-gun Kanagawa 258-8577 (JP)
(74) Representative: Beacham, Annabel Rose
(86) International application number: PCT/JP2016/055237
(87) International publication number: WO 2016/143507

(57) **Abstract**

Provided are: a photoelectric conversion element having a conductive support, a photosensitive layer including an electrolyte, an electric charge transfer layer including an electrolyte, and a counter electrode, wherein the photo sensitive layer has semiconductor fine particles carrying a metal complex dye represented by a specific formula; a dye-sensitized solar cell; and a metal complex dye and a dye solution used for the photoelectric conversion element and the dye-sensitized solar cell.

## Description

### BACKGROUND OF THE INVENTION

### 1. Field of the Invention

The present invention relates to a photoelectric conversion element, a dye-sensitized solar cell, a metal complex dye, and a dye solution.

### 2. Description of the Related Art

Photoelectric conversion elements are used in various photosensors, copying machines, photo electrochemical cells such as solar cells, and the like. These photoelectric conversion elements have adopted various systems to be put into use, such as systems utilizing metals, systems utilizing semiconductors, systems utilizing organic pigments or dyes, or combinations of these elements. In particular, solar cells utilizing inexhaustible solar energy do not necessitate fuels, and full-fledged practicalization of solar cells as an inexhaustible clean energy is being highly expected. Above all, research and development of silicon-based solar cells have long been in progress, and many countries also support policy-wise considerations, and thus dissemination of silicon-based solar cells is still in progress. However, silicon is an inorganic material, and thus, naturally has limitations in terms of improvement of throughput, cost, and the like.

Thus, research is being vigorously carried out on photoelectrochemical cells (also referred to as dye-sensitized solar cells) using metal complex dyes. In particular, what have built momentum toward such research was the research results from Graetzel et al. of École Polytechnique Fédérale de Lausanne in Switzerland. They employed a structure in which a dye formed from a ruthenium complex was fixed on the surface of a porous titanium oxide film, and realized a photoelectric conversion efficiency which was comparable to that of amorphous silicon. Thus, dye-sensitized solar cells that can be produced even without use of expensive vacuum devices have instantly attracted the attention of researchers all over the world.

Hitherto, dyes called N3, N719, N749 (also referred to as Black Dye), Z907, and J2 have generally been developed as metal complex dyes for use in dye-sensitized solar cells.

In addition to these metal complex dyes, various metal complex dyes have been studied.

For example, in US2009/0107552A, a dye (Compound 1) having a terpyridine ligand having a 5'-carboxy-2,2'-bithiophenyl group in a pyridine ring at the center and three monodentate ligands is specifically described (at page 8 of this publication).

In JP2013-229285A, a dye having at least one specific ligand having a substituent such as an alkyl group at a specific position of a cyclic group is described. Further, in this publication, as a tridentate ligand having at least one acidic group which can be adopted by a dye, a terpyridine ligand having a phenylethynylene group is described (paragraph [0267] of this publication).

In JP2012-36237A, a metal complex dye having a terpyridine ligand or bipyridine ligand having a substituent Q (General Formula (4) in this publication) containing a specific group Y¹ such as ethenylene, and a monodentate ligand or bidentate ligand is described (claim 1, paragraph [0042], and the like of this publication).

### SUMMARY OF THE INVENTION

However, photoelectric conversion elements and dye-sensitized solar cells are increasingly required to have higher performance every year, and there is a demand for, in particular, further modifications and improvements in their photoelectric conversion efficiency.

Furthermore, in the photoelectric conversion elements and the dye-sensitized solar cells, a layer formed of semiconductor fine particles carrying a metal complex dye (also referred to as a semiconductor layer) is usually formed as a layer having a thickness of ten to several hundred µm. At this time, the photoelectric conversion efficiency varies depending on the film thickness of the semiconductor layer, and accordingly, there is a tendency that the photoelectric conversion efficiency is reduced as the film thickness decreases. It could be freshly seen that for metal complex dyes in the related art, in a case where the film thickness of a semiconductor layer is ten to several hundred µm as well as a case where the semiconductor layer is even thinner, the photoelectric conversion efficiency cannot be necessarily satisfactory.

Hitherto, improvement of the photoelectric conversion efficiency has been actively studied, but the relationship between the film thickness of the semiconductor layer and photoelectric conversion efficiency has been rarely found and is not described in the publication.

The present invention has an object to provide a photoelectric conversion element and a dye-sensitized solar cell, each of which is less affected by the film thickness of a semiconductor layer and exhibits excellent photoelectric conversion efficiency, particularly even when the film thickness is small; and a metal complex dye and a dye solution, each of which is used in the photoelectric conversion element and the dye-sensitized solar cell.

The present inventors have conducted various investigations on a metal complex dye for use in a photoelectric conversion element and a dye-sensitized solar cell, and have thus found that use of a ligand formed by combining a tridentate ligand coordinating to a metal ion of an metal complex dye through a lone electron pair of a ring-constituting atom as a ligand adsorbed on semiconductor fine particles (also referred to as an acceptor ligand) with a monodentate ligand or a bidentate ligand coordinating to at least one anion as a ligand not adsorbed on semiconductor fine particles (also referred to as a donor ligand), and incorporation of an ethynylene group having an aromatic ring group bonded to a specific ring constituting an acceptor ligand are important in improvement of photoelectric conversion efficiency and realization of high photoelectric conversion efficiency even when the semiconductor layer is a thin film. Based on these findings, the present invention has been completed.

That is, the objects of the present invention have been achieved by the following means.
<1> A photoelectric conversion element comprising an electrically conductive support, a photoconductor layer including an electrolyte, a charge transfer layer including an electrolyte, and a counter electrode, in which the photoconductor layer has semiconductor fine particles carrying a metal complex dye represented by Formula (1).

   Formula (1) M(LA)(Z)_{nZ}·CI_{mY}

   In Formula (1),
   M represents a metal ion.
   LA represents a tridentate ligand represented by Formula (AL-1).

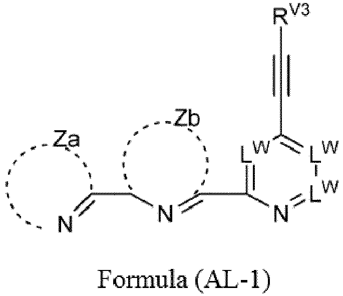

   In the formula, Za and Zb each independently represent a non-metal atomic group necessary for completing a 5- or 6-membered ring, in which at least one of rings formed by Za and Zb, respectively, has one or more acidic groups. L^{W}'s each independently represent a nitrogen atom or CR^{W}, and R^{W} represents a hydrogen atom or a substituent. R^{V3} represents an aryl group or a heteroaryl group.
   Z represents a ligand selected from the group consisting of an acyloxy group, an acylthio group, a thioacyloxy group, a thioacylthio group, an acylaminooxy group, a thiocarbamate group, a dithiocarbamate group, a thiocarbonate group, a dithiocarbonate group, a trithiocarbonate group, an acyl group, a thiocyanate group, an isothiocyanate group, a cyanate group, an isocyanate group, a selenocyanate group, an isoselenocyanate group, a cyano group, an isocyano group, an alkylthio group, an arylthio group, an alkoxy group, an aryloxy group, a halogen atom, carbonyl, dialkylketone, 1,3-diketone, carbonamide, thiocarbonamide, and thiourea. nZ represents 2 or 3.
   CI represents a counterion in a case where the counterion is necessary for neutralizing the charge. mY represents an integer of 0 to 3.
<2> The photoelectric conversion element as described in <1>, in which the ring formed by Za is at least one selected from the group consisting of a pyridine ring, a pyrimidine ring, a pyrazine ring, a pyridazine ring, a triazine ring, a tetrazine ring, a quinoline ring, an isoquinoline ring, a pyrazole ring, an imidazole ring, a triazole ring, a thiazole ring, an oxazole ring, a benzimidazole ring, a benzotriazole ring, a benzoxazole ring, and a benzothiazole ring,
   the ring formed by Zb is at least one selected from the group consisting of a pyridine ring, a pyrimidine ring, a pyrazine ring, a pyridazine ring, a triazine ring, a tetrazine ring, a quinoline ring, an isoquinoline ring, an imidazole ring, a triazole ring, a thiazole ring, an oxazole ring, a benzimidazole ring, a benzotriazole ring, a benzoxazole ring, and a benzothiazole ring, and
   the ring including L^{W} is at least one selected from the group consisting of a pyridine ring, a pyrimidine ring, a pyridazine ring, a triazine ring, a tetrazine ring, and a quinoline ring.
<3> The photoelectric conversion element as described in <1> or <2>, in which LA is a tridentate ligand represented by Formula (AL-2). 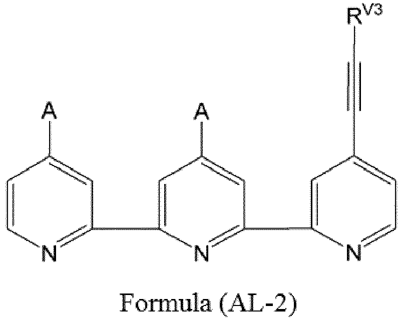
   In the formula, A represents an acidic group. R^{V3} has the same definition as R^{V3} in Formula (AL-1).
<4> The photoelectric conversion element as described in any one of <1> to <3>, in which the acidic group is a carboxyl group or a salt thereof.
<5> The photoelectric conversion element as described in any one of <1> to <4>, in which the aryl group or heteroaryl group of R^{V3} is a monocycle bonded to the ethynylene group in Formula (AL-1) or a polycyclic group containing the monocycle as a fused ring, and in a case where this monocycle is a 5-membered ring, it has a substituent on at least one of sp² carbon atoms at the α-position with respect to the ring-constituting atom bonded to the ethynylene group, and in a case where the monocycle is a 6-membered ring, it has a substituent on at least one of sp² carbon atoms at the α-position and the β-position with respect to the ring-constituting atom bonded to the ethynylene group.
<6> The photoelectric conversion element as described in any one of <1> to <5>, in which the aryl group or heteroaryl group of R^{V3} is a group represented by any one of Formulae (V-1) to (V-3). 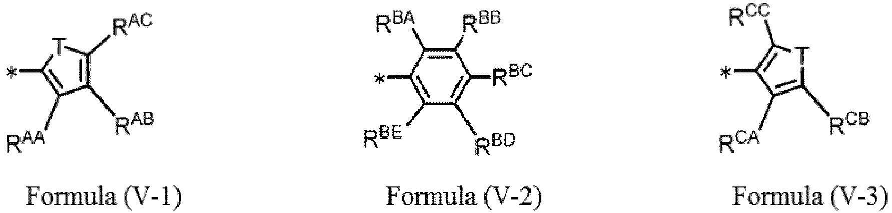
   In the formulae, T represents -O-, -S-, -NR^{T}-, -C(R^{T})₂-, or -Si(R^{T})₂-, and R^{T}'s each represent a hydrogen atom or a substituent.
   R^{AA} represents a substituent, and R^{AB} and R^{AC} each independently represent a hydrogen atom or a substituent.
   R^{BA} to R^{BE} each independently represent a hydrogen atom or a substituent, and at least one of R^{BA}, R^{BB}, R^{BD}, or R^{BE} represents a substituent.
   R^{CA} to R^{CC} each independently represent a hydrogen atom or a substituent, and at least one of R^{CA} or R^{CC} represents a substituent.
   * represents a bonding moiety to the ethynylene group in Formula (AL-1).
<7> The photoelectric conversion element as described in <5> or <6>, in which the substituent is an alkyl group or alkoxy group having 3 to 12 carbon atoms.
<8> The photoelectric conversion element as described in any one of <1> to <7>, in which Z is a ligand selected from the group consisting of a thiocyanate group, an isothiocyanate group, a halogen atom, a cyano group, a cyanate group, an isocyanate group, an alkylthio group, an arylthio group, an alkoxy group, an aryloxy group, a ligand represented by Formula (XA-1), and a ligand represented by Formula (XA-2). 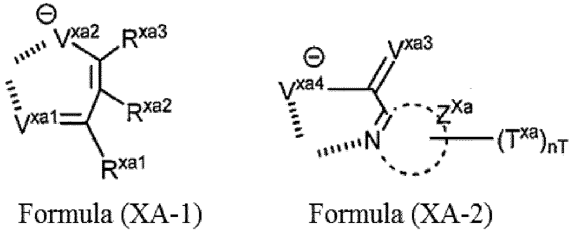
   In the formulae, V^{xa1} to V^{xa4} each independently represent a sulfur atom or an oxygen atom. R^{xa1} to R^{xa3} each independently represent a hydrogen atom or a substituent. Z^{Xa} represents a non-metal atomic group necessary for completing a 5- or 6-membered ring. T^{xa} represents a substituent, and nT represents an integer of 0 to 4. The dotted line represents a bonding moiety to the metal ion M.
<9> The photoelectric conversion element as described in any one of <1> to <8>, in which Z is an isothiocyanate group, a ligand represented by Formula (XA-1b), or a ligand represented by Formula (XA-2b). 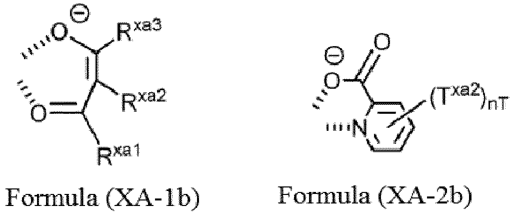
   In the formulae, R^{xa1} to R^{xa3} each independently represent a hydrogen atom or a substituent. T^{xa2} represents a substituent and nT represents an integer of 0 to 4. The dotted line represents a bonding moiety to the metal ion M.
<10> The photoelectric conversion element as described in any one of <1> to <9>, in which M is Ru²⁺ or Os²⁺.
<11> A dye-sensitized solar cell comprising the photoelectric conversion element as described in any one of <1> to <10>.
<12> A metal complex dye represented by Formula (1).

   Formula (1) M(LA)(Z)_{nZ}·CI_{mY}

   In Formula (1),
   M represents a metal ion.
   LA represents a tridentate ligand represented by Formula (AL-1).

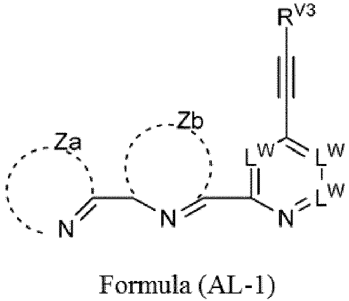

   In the formula, Za and Zb each independently represent a non-metal atomic group necessary for completing a 5- or 6-membered ring, in which at least one of rings formed by Za and Zb, respectively, has one or more acidic groups. L^{W}'s each independently represent a nitrogen atom or CR^{W}, and R^{W} represents a hydrogen atom or a substituent. R^{V3} represents an aryl group or a heteroaryl group.
   Z represents a ligand selected from the group consisting of an acyloxy group, an acylthio group, a thioacyloxy group, a thioacylthio group, an acylaminooxy group, a thiocarbamate group, a dithiocarbamate group, a thiocarbonate group, a dithiocarbonate group, a trithiocarbonate group, an acyl group, a thiocyanate group, an isothiocyanate group, a cyanate group, an isocyanate group, a selenocyanate group, an isoselenocyanate group, a cyano group, an isocyano group, an alkylthio group, an arylthio group, an alkoxy group, an aryloxy group, a halogen atom, carbonyl, dialkylketone, 1,3-diketone, carbonamide, thiocarbonamide, and thiourea. nZ represents 2 or 3.
   CI represents a counterion in a case where the counterion is necessary for neutralizing the charge. mY represents an integer of 0 to 3.
<13> A dye solution comprising the metal complex dye as described in <12> and a solvent.

In the present specification, unless otherwise specified, in a case where the E configuration or the Z configuration exists in the molecule for a double bond, the double bond may be either one of the two configurations or a mixture thereof.

When there are a plurality of substituents, linking groups, ligands, or the like (hereinafter referred to as substituents or the like) represented by specific symbols, or when a plurality of substituents and the like are defined at the same time, the respective substituents or the like may be the same as or different from each another unless otherwise specified. This also applies to the definition of the number of substituents or the like. Further, when a plurality of substituents and the like are close to each other (in particular, adjacent to each other), they may be linked to each other to form a ring, unless otherwise specified. Further, the ring, for example, an alicycle, an aromatic ring, or a heterocycle may further be fused to form a fused ring.

In the present specification, expressions of a compound (including a complex and a dye) are meant to encompass, in addition to the compound itself, salts and ions of the compound. Further, within a range exhibiting desired effects, the expressions are used to mean inclusion of modifications of a part of the structure. In addition, a compound in which substitution or non-substitution is not explicitly described is meant to indicate that compound may have an arbitrary substituent within a range exhibiting the desired effects. This also applies to substituents, linking groups, and ligands.

Moreover, in the present specification, a numerical value range represented by "(a value) to (a value)" means a range including the numerical values represented before and after "to" as a lower limit value and an upper limit value, respectively.

By incorporating a metal complex dye using a combination of a tridentate ligand LA represented by Formula (AL-1) and a specific ligand Z into the photoelectric conversion element and the dye-sensitized solar cell of the present invention, the effect of the film thickness of the semiconductor layer is small and excellent photoelectric conversion efficiency is exerted. Accordingly, according to the present invention, it is possible to provide a photoelectric conversion element and a dye-sensitized solar cell, having a small effect of the film thickness of the semiconductor layer and exerting excellent photoelectric conversion efficiency, in particular, even when the film thickness is small, as well as a metal complex dye and a dye solution used therein.

The above or other characteristics and advantages of the present invention will be further clarified from the following description with reference to drawings appropriately attached hereto.

### BRIEF DESCRIPTION OF THE DRAWINGS

Fig. 1 is a cross-sectional view schematically showing a photoelectric conversion element in the first aspect of the present invention, including an enlarged view of the circled portion in the layer thereof, in a system in which the photoelectric conversion element is applied in cell uses.
Fig. 2 is a cross-sectional view schematically showing a dye-sensitized solar cell including a photoelectric conversion element in the second aspect of the present invention.

### DESCRIPTION OF THE PREFERRED EMBODIMENTS

### [Photoelectric Conversion Element and Dye-Sensitized Solar Cell]

The photoelectric conversion element of the present invention has an electrically conductive support, a photoconductor layer including an electrolyte, a charge transfer layer including an electrolyte, and a counter electrode (opposite electrode). The photoconductor layer, the charge transfer layer, and the counter electrode are provided in this order on the electrically conductive support.

In the photoelectric conversion element of the present invention, at least a portion of the semiconductor fine particles forming the photoconductor layer carries a metal complex dye represented by Formula (1) which will be described later, as a sensitizing dye. Here, the aspect in which the metal complex dye is carried on the surface of the semiconductor fine particles encompasses an aspect in which the metal complex dye is deposited on the surface of the semiconductor fine particles, an aspect in which the metal complex dye is adsorbed onto the surface of the semiconductor fine particles, and a mixture of the aspects. The adsorption includes chemical adsorption and physical adsorption, with the chemical adsorption being preferable.

The semiconductor fine particles may carry other metal complex dyes, together with the metal complex dye of Formula (1) which will be described later.

Moreover, the photoconductor layer includes an electrolyte. The electrolyte included in the photoconductor layer may be the same as or different from the electrolyte included in the charge transfer layer, but they are preferably the same.

The photoelectric conversion element of the present invention is not particularly limited in terms of configurations other than the configuration defined in the present invention, and may adopt known configurations regarding photoelectric conversion elements. The respective layers constituting the photoelectric conversion element of the present invention are designed depending on purposes, and may be formed into, for example, a single layer or multiple layers. Further, layers other than the layers may be included, as necessary.

The dye-sensitized solar cell of the present invention is formed by using the photoelectric conversion element of the present invention.

Hereinafter, preferred embodiments of the photoelectric conversion element and the dye-sensitized solar cell of the present invention will be described.

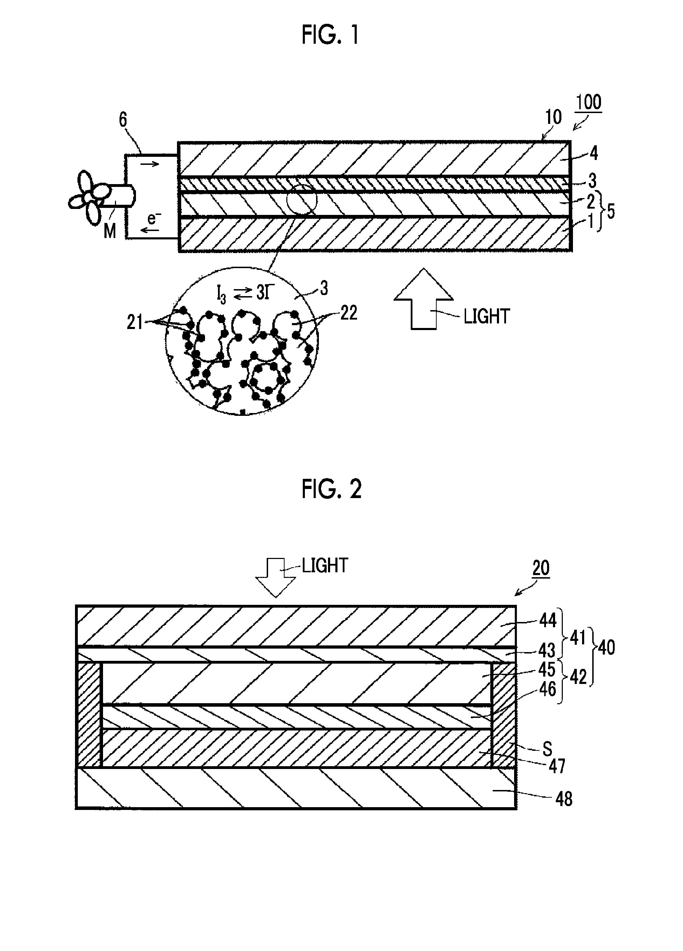

A system 100 shown in Fig. 1 is a system in which a photoelectric conversion element 10 in the first aspect of the present invention is applied in cell uses where an operating means M (for example, an electric motor) in an external circuit 6 is forced to work.

The photoelectric conversion element 10 includes semiconductor fine particles 22 sensitized by carrying an electrically conductive support 1 and a dye (metal complex dye) 21, a photoconductor layer 2 including an electrolyte between the semiconductor fine particles 22, a charge transfer layer 3 that is a hole transport layer, and a counter electrode 4.

In the photoelectric conversion element 10, the light-receiving electrode 5 has the electrically conductive support 1 and the photoconductor layer 2, and functions as a functional electrode.

In the system 100 in which the photoelectric conversion element 10 is applied, light incident to the photoconductor layer 2 excites the metal complex dye 21. The excited metal complex dye 21 has electrons having high energy, and these electrons are transferred from the metal complex dye 21 to a conduction band of the semiconductor fine particles 22, and further reach the electrically conductive support 1 by diffusion. At this time, the metal complex dye 21 is in an oxidized form (cation). While the electrons reaching the electrically conductive support 1 work in an external circuit 6, they reach the oxidized form of the metal complex dye 21 through the counter electrode 4 and the charge transfer layer 3, and reduce the oxidized form, whereby the system 100 functions as a solar cell.

A dye-sensitized solar cell 20 shown in Fig. 2 is constituted with a photoelectric conversion element in the second aspect of the present invention.

With respect to the photoelectric conversion element shown in Fig. 1, the photoelectric conversion element which becomes the dye-sensitized solar cell 20 is different in the configurations of the electrically conductive support 41 and the photoconductor layer 42, and also differs in that it has a spacer S, but except for these, has the same structure as the photoelectric conversion element 10 shown in Fig. 1. That is, the electrically conductive support 41 has a bilayered structure including a substrate 44 and a transparent electrically-conductive film 43 which is formed on the surface of the substrate 44. Further, the photoconductor layer 42 has a bilayered structure including a semiconductor layer 45 and a light-scattering layer 46 which is formed adjacent to the semiconductor layer 45. A spacer S is provided between the electrically conductive support 41 and the counter electrode 48. In the dye-sensitized solar cell 20, 40 is a light-receiving electrode and 47 is a charge transfer layer.

The dye-sensitized solar cell 20, similar to the system 100 in which the photoelectric conversion element 10 is applied, functions as a solar cell by light incident on the photoconductor layer 42.

The photoelectric conversion element and the dye-sensitized solar cell of the present invention are not limited to the above preferred aspects, and the configuration of each of the aspects can be combined as appropriate within a range not departing from the scope of the present invention.

In the present invention, the materials and the respective members for use in the photoelectric conversion element and the dye-sensitized solar cell can be prepared by ordinary methods. Reference can be made to, for example, US4927721A, US4684537A, US5084365A, US5350644A, US5463057A, US5525440A, JP1985-249790A (JP-H07-249790A), JP2001-185244A, JP2001-210390A, JP2003-217688A, JP2004-220974A, and JP2008-135197A.

### <Metal Complex Dye Represented by Formula (1)>

The metal complex dye for use in the present invention is represented by Formula (1). The metal complex dye of the present invention can impart high photoelectric conversion efficiency to the photoelectric conversion element and the dye-sensitized solar cell, irrespective of the film thickness of the semiconductor layer, by including both of the following ligand LA and the following ligand Z. Accordingly, the metal complex dye of the present invention is preferably used as a sensitizing dye in the dye-sensitized solar cell.

Formula (1) M(LA)(Z)_{nZ}·CI_{mY}

In Formula (1), M represents a metal ion.

LA represents a tridentate ligand represented by Formula (AL-1).

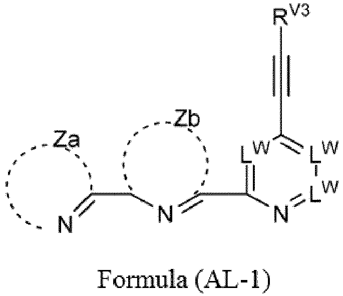

In Formula (AL-1), Za and Zb each independently represent a non-metal atomic group required for forming a 5- or 6-membered ring. Here, at least one of the rings formed by Za and Zb has one or more acidic groups. L^{W}'s each independently represent a nitrogen atom or CR^{W}, and R^{W} represents a hydrogen atom or a substituent. R^{V3} represents an aryl group or a heteroaryl group.

Z represents a ligand selected from the group consisting of an acyloxy group, an acylthio group, a thioacyloxy group, a thioacylthio group, an acylaminooxy group, a thiocarbamate group, a dithiocarbamate group, a thiocarbonate group, a dithiocarbonate group, a trithiocarbonate group, an acyl group, a thiocyanate group, an isothiocyanate group, a cyanate group, an isocyanate group, a selenocyanate group, an isoselenocyanate group, a cyano group, an isocyano group, an alkylthio group, an arylthio group, an alkoxy group, an aryloxy group, a halogen atom, carbonyl, dialkylketone, 1,3-diketone, carbonamide, thiocarbonamide, and thiourea. nZ represents 2 or 3.

CI represents a counterion in a case where the counterion is necessary for neutralizing the charge. mY represents an integer of 0 to 3, and is preferably 0 or 1.

### - Metal Ion M -

M is a central metal ion of the metal complex dye, and examples thereof include ions of elements belonging to Groups 6 to 12 on the long-form periodic table of the elements. Examples of such metal ions include respective ions of Ru, Fe, Os, Cu, W, Cr, Mo, Ni, Pd, Pt, Co, Ir, Rh, Re, Mn, and Zn. The metal ion M may be one kind of ion, or two or more kinds of ions.

In the present invention, the metal ion M is preferably Os²⁺, Ru²⁺, or Fe²⁺, more preferably Os²⁺ or Ru²⁺, and particularly preferably Ru²⁺ among them.

In addition, in a state of being incorporated in the photoelectric conversion element, the valence of M may be changed by the redox reaction with the surrounding material.

### - Ligand LA -

The ligand LA is a tridentate ligand or compound which is represented by Formula (AL-1) and coordinates to a metal ion M through three nitrogen atoms in Formula (AL-1). Further, the ligand LA has at least one acidic group (also referred to as an adsorptive group) on at least one of the ring formed by Za and the ring formed by Zb, each of which will be described later. The ligand LA is a ligand which makes the metal complex dye of the present invention carried on the semiconductor fine particles.

In Formula (AL-1), Za and Zb each independently represent a non-metal atomic group necessary for forming a 5-membered ring or a 6-membered ring. Za and Zb are each preferably a non-metal atomic group selected from a carbon atom and the heteroatoms, and more preferably a non-metal atomic group selected from a carbon atom, a nitrogen atom, an oxygen atom, a sulfur atom, and a phosphorus atom.

The rings formed by Za and Zb are preferably an aromatic ring of a 5-membered ring and an aromatic ring of a 6-membered ring. As the aromatic ring of a 5-membered ring, at least one of a pyrazole ring, an imidazole ring, a triazole ring, a thiazole ring, an oxazole ring, a benzimidazole ring, a benzotriazole ring, a benzoxazole ring, and a benzothiazole ring is preferable. As the aromatic ring of a 6-membered ring, at least one of a pyridine ring, a pyrimidine ring, a pyrazine ring, a pyridazine ring, a triazine ring, a tetrazine ring, a quinoline ring, and an isoquinoline ring is preferable.

As the rings formed by Za and Zb, an aromatic ring which is suitable for the structure of each ring represented by Formula (AL-1) is preferably selected from a group of the aromatic rings of 5-membered rings and a group of the aromatic rings of 6-membered rings.

The ring formed by Za is preferably at least one selected from the group consisting of a pyridine ring, a pyrimidine ring, a pyrazine ring, a pyridazine ring, a triazine ring, a tetrazine ring, a quinoline ring, an isoquinoline ring, a pyrazole ring, an imidazole ring, a triazole ring, a thiazole ring, an oxazole ring, a benzimidazole ring, a benzotriazole ring, a benzoxazole ring, and a benzothiazole ring.

The ring formed by Zb is preferably at least one selected from the group consisting of a pyridine ring, a pyrimidine ring, a pyrazine ring, a pyridazine ring, a triazine ring, a tetrazine ring, a quinoline ring, an isoquinoline ring, an imidazole ring, a triazole ring, a thiazole ring, an oxazole ring, a benzimidazole ring, a benzotriazole ring, a benzoxazole ring, and a benzothiazole ring.

Among those, the rings formed by Za and Zb are more preferably an imidazole ring, a pyridine ring, or a quinoline ring, and particularly preferably, they are all pyridine rings.

At least one of the rings formed by Za and Zb has one or more acidic groups, and it is preferable that each of the rings has one or more acidic groups. The number of the acidic groups contained in each of the rings formed by Za and Zb is preferably 1 to 3, more preferably 1 or 2, and still more preferably 1. It is more preferable that these rings each have one acidic group.

The rings formed by Za and Zb may not each have a substituent other than the acidic group, and may be a monocycle or a fused ring. Examples of the substituent which may be contained include groups (excluding an acidic group) selected from the substituent group T which will be described later.

In the present invention, the acidic group is a substituent which has a dissociative proton and has a pKa of 11 or less. The pKa of the acidic group can be determined in accordance with the "SMD/M05-2X/6-31G*" method described in J. Phys. Chem. A2011, 115, pp. 6641-6645. Examples thereof include an acid group showing acidity, such as a carboxyl group, a phosphonyl group, a phosphoryl group, a sulfo group, and a boric acid group; and groups having these acid groups. Examples of the group having an acid group include groups having an acid group and a linking group. The linking group is not particularly limited, and examples thereof include a divalent group, and preferably an alkylene group, an alkenylene group, an alkynylene group, an arylene group, and a heteroarylene group. This linking group may have a group selected from the substituent group T which will be described later as a substituent. Preferred examples of the acidic group having an acid group and a linking group include carboxymethyl, carboxyvinylene, dicarboxyvinylene, cyanocarboxyvinylene, 2-carboxy-1-propenyl, 2-carboxy-1-butenyl, and carboxyphenyl.

The acidic group is preferably a carboxyl group or a group having a carboxyl group, and more preferably a carboxyl group.

The acidic group may be in the form of a dissociated anion due to release of a proton or in the form of a salt when the acidic group is included in the metal complex dye represented by Formula (1). In a case where the acidic group is in the form of a salt, the counterion is not particularly limited, and examples thereof include those exemplified as positive ions in the following counterion CI. In addition, the acidic group may be esterified as described later.

In the rings formed by Za and Zb, the substitution position of the acidic group is not particularly limited. In the respective rings, the substitution position is preferably a ring-constituting atom which is the farthest from a nitrogen atom which coordinates to a metal ion M is preferable, and in a case where the ring is a 6-membered ring, the substitution position is preferably the 4-position with respect to the nitrogen atom.

In Formula (AL-1), a ring formed by a nitrogen atom, a carbon atom, and L^{W} (also referred to as a ring including L^{W} and the like) has the following group R^{V3}, and preferably, does not have an acidic group. The ring including L^{W} and the like may be a monocycle or a fused ring. L^{W} represents a nitrogen atom or CR^{W}. R^{W} represents a hydrogen atom or a substituent (monovalent), and is preferably a hydrogen atom. The substituent that can be adopted by R^{W} is not particularly limited, and examples thereof include a group (preferably excluding the acidic group and the following group R^{V3}) selected from the substituent group T which will be described later. In a case where the ring including L^{W} and the like has a plurality of R^{W}'s, the plurality of R^{W}'s may be the same as or different from each other, and R^{W}'s may also be bonded to each other to form a ring.

As the ring including L^{W} and the like, a ring which is suitable for the ring structure in Formula (AL-1) is preferably selected from the aromatic rings of 6-membered rings described as the rings formed by Za and Zb. The ring including L^{W} and the like is more preferably at least one of a pyridine ring, a pyrimidine ring, a pyridazine ring, a triazine ring, a tetrazine ring, and a quinoline ring, and particularly preferably a pyridine ring.

Incorporation of the -C≡C-R^{V3} group into the ring-constituting carbon atom at the 4-position with respect to the ring-constituting nitrogen atom which coordinates to the metal ion M of the ring including L^{W} and the like in the ligand LA used in combination with the following ligand Z in the metal complex dye can contribute to improvement of photoelectric conversion efficiency.

R^{V3} represents an aryl group or a heteroaryl group.

The aryl group may be a monocyclic hydrocarbon ring group exhibiting aromaticity or a ring group formed of a hydrocarbon ring exhibiting aromaticity, formed by fusion of two or more rings (a fused polycyclic aromatic ring group).

The monocyclic hydrocarbon ring group is preferably a 6-membered ring, and examples thereof include a benzene ring group.

Preferred examples of the fused polycyclic aromatic ring group include a hydrocarbon ring formed by fusion of two or more 5- or 6-membered rings, including, for example, a hydrocarbon ring group formed by fusion of a plurality of monocyclic hydrocarbon rings exhibiting aromaticity (benzene rings). Examples of such the fused polycyclic aromatic ring group include a ring group formed by fusion of two or more benzene rings, or cyclopentadiene rings and the like, including, for example, the respective groups of a naphthalene ring, an anthracene ring, a phenanthrene ring, a tetracene ring, a pentacene ring, a hexacene ring, a heptacene ring, a chrysene ring, a picene ring, a pyrene ring, a perylene ring, a coronene ring, an ovalene ring, a fluorene ring, or a triphenylene ring. Here, the number of fused hydrocarbon rings is not particularly limited, and for example, it is preferably 2 to 10, more preferably 2 to 5, and still more preferably 2 or 3.

As the aryl group, the respective groups of a benzene ring, a naphthalene ring, an anthracene ring, a phenanthrene ring, a triphenylene ring, a pyrene ring, a fluorene ring, and the like are preferable, the respective groups of a benzene ring, a naphthalene ring, a pyrene ring, a fluorene ring, and the like are more preferable, and a benzene ring, a naphthalene ring, or a fluorene ring is still more preferable.

Examples of the heteroaryl group include a monocyclic heterocyclic group exhibiting aromaticity, and the fused polycyclic heterocyclic group in which a plurality of ring groups including a heterocycle are fused.

As the monocyclic heterocyclic group, a 5-membered ring or 6-membered ring group including a heteroatom as a ring-constituting atom is preferable. The heteroatom is not particularly limited, but examples thereof include a nitrogen atom, an oxygen atom, a sulfur atom, a silicon atom, a selenium atom, and a phosphorus atom. Examples of the 5-membered ring group include the respective groups of a thiophene ring, a furan ring, a pyrrole ring, a selenophene ring, a thiazole ring, an oxazole ring, an isothiazole ring, an isoxazole ring, an imidazole ring, a pyrazole ring, a thiadiazole ring, an oxadiazole ring, a silole ring, a triazole ring, or the like. Examples of the group of a 6-membered ring include the respective groups of a pyridine ring, a pyrazine ring, a pyrimidine ring, a pyridazine ring, a triazine ring, a tetrazine ring, or the like.

Examples of the fused polycyclic heterocyclic group include a ring group formed by fusion of a plurality of monocyclic heterocycles, and a ring group formed by fusion of a plurality of monocyclic heterocycles and hydrocarbon rings. Preferred examples thereof include a ring group formed by fusion of a plurality of homogeneous or heterogeneous ring groups selected from the group consisting of the respective groups of a benzene ring, a cyclopentadiene ring, a thiophene ring, a furan ring, a pyrrole ring, a selenophene ring, a silole ring, a thiazole ring, an oxazole ring, an isothiazole ring, an isoxazole ring, an imidazole ring, a pyrazole ring, a thiadiazole ring, an oxadiazole ring, a pyridine ring, a pyrazine ring, a pyrimidine ring, a pyridazine ring, a triazine ring, and a tetrazine ring. Here, the number of rings to be fused is not particularly limited, and is, for example, preferably 2 to 10, more preferably 2 to 5, and still more preferably 2 or 3.

Examples of the fused polycyclic heterocyclic group include the respective groups of a benzofuran ring, a dibenzofuran ring, an isobenzofuran ring, a benzothiophene ring, a dibenzothiophene ring, a benzisothiophene ring, a benzimidazole ring, a dibenzopyrrole ring, a silafluorene ring (dibenzosilole ring), an indazole ring, an indole ring, an isoindole ring, an indolizine ring, a quinoline ring, an isoquinoline ring, a thienopyridine ring, a cyclopentadifuran ring, a cyclopentadithiophene ring, a thieno[3,2-b]thiophene ring, a thieno[3,4-b]thiophene ring, a trithiophene ring, a benzodifuran ring, a benzodithiophene ring, a dithienopyrrole ring, a dithienosilole ring, and the like.

As the heteroaryl group, a thiophene ring group, a furan ring group, a pyrrole ring group, a selenophene ring group, a thiazole ring group, a benzothiophene ring group, a benzofuran ring group, a thieno[3,2-b]thiophene ring group, or a thieno[3,4-b]thiophene ring group is more preferable, and a thiophene ring group, a furan ring group, a thiazole ring group, a thieno[3,2-b]thiophene ring group, or a thieno[3,4-b]thiophene ring group is still more preferable.

In view of high effects of improving photoelectric conversion efficiency, R^{V3} is preferably a ring group having high electron donating properties, a fused polycyclic aromatic ring group and a heteroaryl group are more preferable, and a heteroaryl group is particularly preferable.

As R^{V3}, one ring group (monocycle) selected from the group consisting of the respective ring groups of a benzene ring, a thiophene ring, a furan ring, a pyrrole ring, a selenophene ring, and a thiazole ring, or a ring group formed by linkage or fusion of a plurality of homogeneous or heterogeneous rings selected from the above groups is preferable, a benzene ring, a thiophene ring, or a furan ring is more preferable, and a thiophene ring is particularly preferable.

The aryl group and the heteroaryl group of R^{V3} may each independently have a substituent, and in this case, examples of the substituent include a group selected from the substituent group T which will be described later (excluding an acidic group), preferably including, for example, the substituents described as R^{AA} which will be described later. In a case where these groups are present in plural numbers, the adjacent groups may be linked to each other to form a ring. As a group which can form a ring, an -O-R^{ve}-O- group having two alkoxy groups linked thereto is preferable. Here, R^{ve} represents an alkylene group, and examples thereof include ethylene and propylene. Examples of those having such groups include a monocyclic heterocyclic group having an -O-R^{ve}-O-group, and more specifically, alkylenedio xythiophene.

In a case where R^{V3} has a substituent, the atom to which the substituent is bonded (substitution position) is not particularly limited. For example, the atom may be any of ring-constituting atoms constituting the aryl group and the heteroaryl group of R^{V3}, or may be an atom constituting another substituent which R^{V3} has.

In the present invention, from the viewpoint of photoelectric conversion efficiency, it is preferable that the aryl group and the heteroaryl group of R^{V3} are each independently a group in which a specific sp² carbon atom among the ring-constituting atoms constituting a monocycle bonded to the ethynylene group in Formula (AL-1) has a substituent.

That is, in a case where R^{V3} is a monocycle bonded to the ethynylene group in Formula (AL-1), or an aryl group or heteroaryl group including the monocycle as a fused ring, and the monocycle is a 5-membered ring, it is preferably the aryl group or heteroaryl group in which at least one of the sp² carbon atoms at the α-position (adjacent position) with respect to the ring-constituting atom bonded to the ethynylene group has a substituent. In a case where the monocycle is a 6-membered ring, it is preferably an aryl group or heteroaryl group in which at least one of the sp² carbon atoms at the α-position (adjacent position) and the β-position with respect to the ring-constituting atom bonded to the ethynylene group has a substituent.

R^{V3} may not have a substituent in a case where the ring-constituting atom at the α-position in the 5-membered ring, and the ring-constituting atom at the α- and β-positions in the 6-membered ring are not sp² carbon atoms.

The substituent in which the specific sp² carbon atom has is not particularly limited, and examples thereof include the substituents described as R^{AA} which will be described later. At least one of the substituents in which the specific sp² carbon atom has is the substituent itself or a substituent which is bonded to another adjacent substituent and does not form a fused ring with a monocycle. The remaining substituents may be substituents which form a fused ring together with a monocycle.

As R^{V3} having the substituent, a group represented by any one of Formulae (V-1) to (V-3) is preferable, a group represented by Formula (V-1) or Formula (V-2) is more preferable, and a group represented by Formula (V-1) is still more preferable.

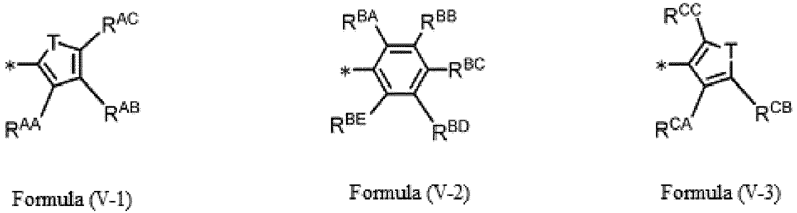

In the formulae, T represents -O-, -S-, -NR^{T}-, -C(R^{T})₂-, or -Si(R^{T})₂-, and R^{T}'s each represent a hydrogen atom or a substituent.

R^{AA} represents a substituent, and R^{AB} and R^{AC} each independently represent a hydrogen atom or a substituent.

R^{BA} to R^{BE} each independently represent a hydrogen atom or a substituent, and at least one of R^{BA}, R^{BB}, R^{BD}, and R^{BE} represents a substituent.

R^{CA} to R^{CC} each independently represent a hydrogen atom or a substituent, and at least one of R^{CA} and R^{CC} represents a substituent.

* represents a bonding moiety to the ethynylene group in Formula (AL-1).

Among those, T is preferably -O- or -S-, and more preferably -S-.

Here, R^{T}'s of -NR^{T}-, -C(R^{T})₂-, and -Si(R^{T})₂- each represent a hydrogen atom or a substituent, with the hydrogen atom being preferable. Examples of the substituent which can be adopted by R^{T} include a group selected from the substituent group T which will be described later.

R^{AA} represents a substituent. The substituent which can be adopted by R^{AA} is not particularly limited, and examples thereof include a group selected from the substituent group T which will be described later. The substituent is preferably an alkyl group, a cycloalkyl group, an alkoxy group, a cycloalkoxy group, an aryloxy group, an alkylthio group, a cycloalkylthio group, an arylthio group, an amino group, an alkylamino group, a cycloalkylamino group, an arylamino group, a heterocycle amino group, a silyl group, or a silyloxy group.

R^{AA} is more preferably an alkyl group, a cycloalkyl group, an alkoxy group, a cycloalkoxy group, an alkylthio group, a cycloalkylthio group, an amino group, an alkylamino group, a cycloalkylamino group, or an arylamino group, still more preferably an alkyl group, a cycloalkyl group, an alkoxy group, a cycloalkoxy group, an alkylamino group, a cycloalkylamino group, or an arylamino group, particularly preferably an alkyl group, an alkoxy group, or an alkylamino group, and most preferably an alkyl group or an alkoxy group.

The substituent which is preferable for R^{AA} is preferably bonded to a thiophene ring (in a case where T is -S-) in view of photoelectric conversion efficiency.

The substituent which can be adopted by R^{AA} may further be substituted with a group selected from the substituent group T which will be described later.

The alkyl group encompasses a linear alkyl group and a branched alkyl group. The number of carbon atoms in the alkyl group is preferably 1 to 30, more preferably 4 to 30, still more preferably 5 to 26, and particularly preferably 6 to 20. Examples of the alkyl group include methyl, ethyl, n-butyl, t-butyl, n-pentyl, n-hexyl, n-octyl, 2-ethylhexyl, n-decyl, 3,7-dimethyloctyl, isodecyl, s-decyl, n-dodecyl, 2-butyloctyl, n-hexadecyl, isohexadecyl, n-eicosy, n-hexacosyl, isooctacosyl, trifluoromethyl, and pentafluoroethyl.

The number of carbon atoms in the cycloalkyl group is preferably 3 to 30, more preferably 5 to 30, still more preferably 6 to 26, and particularly preferably 6 to 20. Examples of the cycloalkyl group include cyclopropyl, cyclopentyl, cyclohexyl, cycloheptyl, and cyclooctyl. The cycloalkyl group may also be fused with an aliphatic ring, an aromatic ring, or a heterocycle.

The alkoxy group encompasses a linear alkoxy group and a branched alkoxy group. The alkyl moiety of the alkoxy group has the same definition as the alkyl group, and preferred examples thereof are also the same. Examples of the alkoxy group include methoxy, ethoxy, n-propoxy, i-propoxy, n-butoxy, t-butoxy, n-pentoxy, n-hexyloxy, n-octyloxy, 2-ethylhexyloxy, 3,7-dimethyloctyloxy, n-decyloxy, isodecyloxy, s-decyloxy, 2-butyloctyloxy, n-dodecyloxy, n-hexadecyloxy, isohexadecyloxy, n-eicosyoxy, n-hexacosyloxy, and isooctacosyloxy.

The cycloalkyl moiety of the cycloalkoxy group has the same definition as the cycloalkyl group, and preferred examples thereof are also the same. Examples of the cycloalkoxy group include cyclopropyloxy, cyclopentyloxy, cyclohexyloxy, cycloheptyloxy, and cyclooctyloxy.

The aryloxy group encompasses a hydrocarbon ring-based aryloxy group in which an aryl group is a hydrocarbon ring, and a heteroaryloxy group in which an aryl group is an aromatic heterocyclic group. The number of carbon atoms in the aryloxy group is preferably 3 to 30, more preferably 3 to 25, still more preferably 3 to 20, and particularly preferably 3 to 16. Examples of the aryloxy group include phenoxy, naphthoxy, imidazolyloxy, benzimidazolyloxy, pyridin-4-yloxy, pyrimidinyloxy, quinazolinyloxy, purinyloxy, and thiophen-3-yloxy. As the heterocycle of the heteroaryloxy group, a thiophene ring is preferable.

The alkylthio group encompasses a linear alkylthio group and a branched alkylthio group. The alkyl moiety of the alkylthio group has the same definition as the alkyl group, and preferred examples thereof are also the same. Examples of the alkylthio group include methylthio, ethylthio, n-propylthio, i-propylthio, n-butylthio, t-butylthio, n-pentylthio, n-hexylthio, n-octylthio, 2-ethylhexylthio, 3,7-dimethyloctylthio, n-decylthio, isodecylthio, s-decylthio, n-dodecylthio, 2-butyloctylthio, n-hexadecylthio, isohexadecylthio, n-eicosythio, n-hexacosylthio, and isooctacosylthio.

The cycloalkyl moiety of the cycloalkylthio group has the same definition as the cycloalkyl group, and preferred examples thereof are also the same. Examples of the cycloalkylthio group include cyclopropylthio, cyclopentylthio, cyclohexylthio, cycloheptylthio, and cyclooctylthio.

The arylthio group encompasses a hydrocarbon ring-based arylthio group in which an aryl group is a hydrocarbon ring, and a heteroarylthio group in which an aryl group is a heterocyclic group The number of carbon atoms in the arylthio group is preferably 3 to 30, more preferably 3 to 25, still more preferably 3 to 20, and particularly preferably 3 to 16. Examples of the arylthio group include phenylthio, naphthylthio, imidazolylthio, benzimidazolylthio, pyridin-4-ylthio, pyrimidinylthio, quinazolinylthio, purinylthio, and thiophen-3-ylthio. As the heterocycle of the heteroarylthio group, a thiophene ring is preferable.

The alkylamino group encompasses an N-alkylamino group and an N,N-dialkylamino group, and the number of carbon atoms in the alkyl group is preferably 1 to 30, and more preferably 2 to 30. Examples of the alkylamino group include ethylamino, diethylamino, 2-ethylhexylamino, bis(2-ethylhexyl)amino, and n-octadecylamino.

The cycloalkylamino group encompasses an N-cycloalkylamino group and an N,N-dicycloalkylamino group. The cycloalkyl moiety of the cycloalkylamino group has the same definition as the cycloalkyl group, and preferred examples thereof are also the same. Examples of the cycloalkylamino group include cyclopropylamino, dicyclopropylamino, N-cyclopropyl-N-ethylamino, cyclopentylamino, dicyclopentylamino, N-cyclopentyl-N-methylamino, cyclohexylamino, dicyclohexylamino, cycloheptylamino, and cyclooctylamino.

The arylamino group encompasses a hydrocarbon-based arylamino group in which an aryl group is a hydrocarbon ring, and a heteroarylamino group in which an aryl group is a heterocyclic group. Further, the hydrocarbon-based arylamino group encompasses an N-arylamino group, an N-alkyl-N-arylamino group, and an N,N-diarylamino group. The heteroarylamino group encompasses an N-heteroarylamino group, an N-alkyl-N-heteroarylamino group, an N-aryl-N-heteroarylamino group, and an N,N-diheteroarylamino group.

The number of carbon atoms in the arylamino group is preferably 3 to 30, more preferably 3 to 25, still more preferably 3 to 20, and particularly preferably 3 to 16. Examples of the arylamino group include phenylamino, N-phenyl-N-ethylamino, naphthylamino, imidazolylamino, benzimidazolylamino, pyridin-4-ylamino, pyrimidinylamino, quinazolinylamino, purinylamino, and thiophen-3-ylamino.

The heterocyclic amino group is a heterocyclic amino group (aliphatic heterocyclic amino group) other than a heteroarylamino group. The number of carbon atoms is preferably 0 to 30, more preferably 1 to 25, still more preferably 2 to 20, and particularly preferably 2 to 16. Further, in the heterocycle, the ring-constituting heteroatom is preferably selected from an oxygen atom, a sulfur atom, and a nitrogen atom, and in terms of the number of ring members, 5- to 7-membered rings are preferable, and 5- or 6-membered rings are more preferable. Examples of the heterocyclic amino group include pyrrolidin-3-ylamino, imidazolidinylamino, benzimidazolidinylamino, piperidin-4-ylamino, and tetrahydrothiophen-3 -ylamino.

The silyl group encompasses an alkylsilyl group, a cycloalkylsilyl group, an arylsilyl group, an alkyloxysilyl group, a cycloalkyloxysilyl group, and an aryloxysilyl group. The silyl group is preferably an alkylsilyl group, a cycloalkylsilyl group, or an arylsilyl group. The number of carbon atoms in the silyl group is preferably 3 to 30, more preferably 3 to 24, still more preferably 3 to 20, and particularly preferably 3 to 18. Examples of the silyl group include trimethylsilyl, triethylsilyl, t-butyldimethylsilyl, cyclohexyldimethylsilyl, triisopropylsilyl, t-butyldiphenylsilyl, methyldimethoxysilyl, phenyldimethoxysilyl, and phenoxydimethylsilyl.

The silyloxy group encompasses an alkylsilyloxy group, a cycloalkylsilyloxy group, and an arylsilyloxy group. The number of carbon atoms in the silyloxy group is preferably 3 to 30, more preferably 3 to 24, still more preferably 3 to 20, and particularly preferably 3 to 18. Examples of the silyloxy group include trimethylsilyloxy, triethylsilyloxy, t-butyldimethylsilyloxy, triisopropylsilyloxy, cyclohexyldimethylsilyloxy, and t-butyldiphenylsilyloxy.

R^{AB} represents a hydrogen atom or a substituent, with a hydrogen atom being preferable.

R^{AC} represents a hydrogen atom or a substituent.

The substituent which can be adopted by R^{AB} and R^{AC} has the same definition as R^{AA}, and preferred examples thereof are also the same. In a case where R^{AB} or R^{AC} is a substituent, the respective substituents of R^{AA} to R^{AC} may be the same as or different from each other.

However, in the group represented by Formula (V-1), R^{AA} is a substituent which does not form a fused ring together with a monocycle (ring including T in Formula (V-1)), and R^{AB} and R^{AC} may also be a substituent which forms a fused ring together with the monocycle.

In a case where R^{AB} and R^{AC} form a fused ring together with the monocycle, the ring group represented by Formula (V-1) is preferably a ring group represented by any one of Formulae (V-1a) to (V-1e), more preferably a ring group represented by any one of Formulae (V-1a) to (V-1c), and still more preferably a ring group represented by Formula (V-1a) or (V-1b).

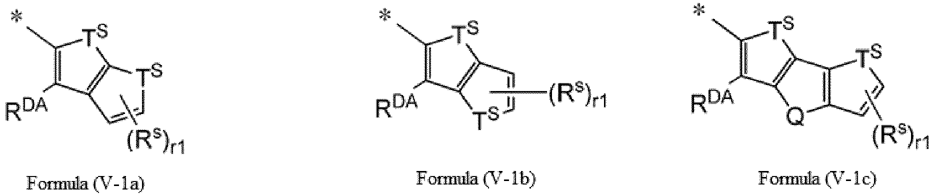

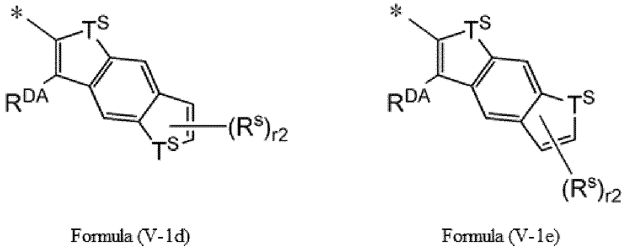

In each of the formulae, T^{S} has the same definition as T in Formula (V-1), preferred examples thereof are also the same, and two of T^{S}'s in each of the formulae may be the same as or different from each other.

R^{DA} represents a substituent. R^{DA} has the same definition as R^{AA} in Formula (V-1), and preferred examples thereof are also the same.

R^{S} represents a substituent. R^{S} has the same definition as the substituent which can be adopted by R^{AB} and R^{AC} in Formula (V-1), and preferred examples thereof are also the same. In Formulae (V-1c) and (V-1d), R^{S} may be bonded to a ring containing Q or a benzene ring. r1 is an integer of 0 to 2, and more preferably 0 or 1. r2 is an integer of 0 to 4, preferably 0 to 2, and more preferably 0 or 1.

Q represents -O-, -S-, -NR^{X2c}, -C(R^{X2c})₂-, -(R^{X2c})C=C(R^{X2c})-, or -Si(R^{X2c})₂-. Among those, Q is preferably -O-, -S-, or -C(R^{X2c})₂-, and more preferably -C(R^{X2c})₂-. Here, R^{X2c} represents a hydrogen atom or a substituent. This substituent has the same definition as R^{T}.

* represents a bonding moiety to the ethynylene group in Formula (AL-1).

In the group represented by Formula (V-2), R^{BA} to R^{BE} each independently represent a hydrogen atom or a substituent. The substituent which can be adopted by each of R^{BA} to R^{BE} has the same definition as R^{AA}, and preferred examples thereof are also the same. However, at least one of R^{BA}, R^{BB}, R^{BD}, or R^{BE} is a substituent. It is particularly preferable that at least one or both of R^{BA} and R^{BE} are a substituent, and all of R^{BB}, R^{BC}, and R^{BD} are a hydrogen atom; or at least one or both of R^{BB} and R^{BD} are a substituent, and all of R^{BA}, R^{BC}, and R^{BE} are a hydrogen atom. Further, at least one substituent of R^{BA}, R^{BB}, R^{BD}, or R^{BE} is a substituent which does not form a fused ring together with the monocycle (benzene ring in Formula (V-2)), and the other substituents may be each a substituent which forms a fused ring together with the monocycle. In a case where two or more members out of R^{BA} to R^{BE} are substituents, two or more substituents may be the same as or different from each other.

In the group represented by Formula (V-3), R^{CA} to R^{CC} each independently represent a hydrogen atom or a substituent. The substituent that can be adopted by each of R^{CA} to R^{CC} has the same definition as that in R^{AA}, and preferred examples thereof are also the same. However, at least one of R^{CA} to R^{CC} is a substituent. At least one of the substituents is a substituent which does not form a fused ring together with a monocycle (ring including T in Formula (V-3)). The other substituents may be a substituent which forms a fused ring together with the monocycle. In a case where two or more of R^{CA} to R^{CC} are substituents, two or more substituents may be the same as or different from each another.

The ligand LA is preferably a tridentate ligand (terpyridine compound) represented by Formula (AL-2). This terpyridine compound can impart excellent photoelectric conversion efficiency to a photoelectric conversion element or a dye-sensitized solar cell by being used in combination with the ligand Z which will be described later as a ligand of a metal complex dye for use in a photoelectric conversion element or a dye-sensitized solar cell. Accordingly, this terpyridine compound is preferably used as a ligand of a dye-sensitized solar cell.

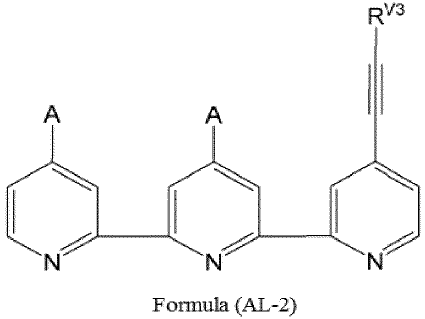

In Formula (AL-2), A represents an acidic group and has the same definition as the acidic group of Formula (AL-1), and preferred examples thereof are also the same.

R^{V3} has the same definition as R^{V3} of Formula (AL-1), and preferred examples thereof are also the same.

The terpyridine compound is the ligand LA itself, but in the present invention, the ligand LA can also be used as a precursor compound of the ligand LA as described later. Accordingly, in the present invention, as a term of the ligand LA is referred to, it encompasses a precursor compound of the ligand LA, in addition to the ligand LA itself (the terpyridine compound). Preferred examples of the precursor compound include an ester form in which at least one of the acidic groups of the terpyridine compound is esterified (also referred to as an esterified product of the terpyridine compound).

This esterified product is a compound having the acidic group protected, which is an ester capable of being regenerated into an acidic group by hydrolysis or the like, and is not particularly limited. Examples thereof include an alkyl esterified product, an aryl esterified product, and a heteroaryl esterified product of the acidic group. Among these, the alkyl esterified product is preferable. The alkyl group which forms an alkyl esterified product is not particularly limited, but an alkyl group having 1 to 10 carbon atoms is preferable, an alkyl group having 1 to 6 carbon atoms is more preferable, and an alkyl group having 1 to 4 carbon atoms is still more preferable. The aryl group which forms an aryl esterified product and the heteroaryl group which forms a heteroaryl esterified product are each not particularly limited, and examples thereof include those exemplified as the substituent group Z^{R} which will be described later. These groups may have at least one substituent selected from the substituent group Z^{R} which will be described later.

It is preferable that two acidic groups to be esterified are used. In this case, the two esters may be the same as or different from each other.

The ligand LA can be synthesized in accordance with ordinary methods. For example, the ligand LA represented by Formula (LI-6) can be synthesized by subjecting a compound represented by Formula (LI-3) and a compound represented by Formula (LI-4) to a coupling reaction, and hydrolyzing an ester group of a precursor compound represented by Formula (L1-5), as shown in the following scheme. In this synthesis method, an esterified product of a carboxyl group is shown as the precursor compound, but the present invention is not limited thereto, and any of precursor compounds obtained by esterification of any one of the acidic groups may be used.

The coupling reaction herein can be carried out by, for example, "a Stille coupling reaction", a "Suzuki coupling method" described in "Experimental Chemistry Course, Fifth Edition", Maruzen Co., Ltd., edited by The Chemical Society of Japan, Vol. 13, pp. 92-117, or methods equivalent thereto. Further, the hydrolysis can be carried out in accordance with, for example, the method described in "Experimental Chemistry Course, Fifth Edition", Maruzen Co., Ltd., edited by The Chemical Society of Japan, Vol. 16, pp. 10-15.

In the present invention, the metal complex dye of the present invention can be synthesized using the ligand LA synthesized by the hydrolysis of the precursor compound. Further, the metal complex dye of the present invention can also be synthesized by forming a metal complex dye using a precursor compound, and then hydrolyzing an ester group in accordance with the above method, as in Example 1 which will be described later.

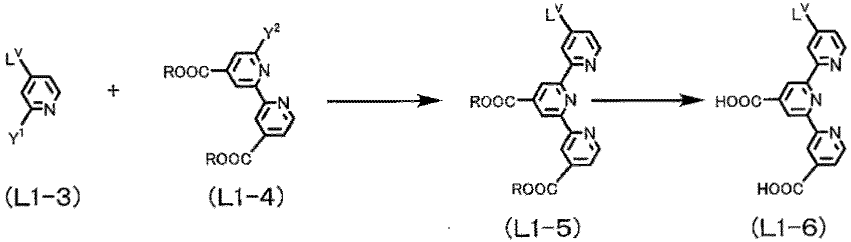

In Formula (LI-3), L^{V} has the same definition as the "-C≡C-R^{V3}" group in Formula (AL-1). Y¹ represents a trialkyl tin group, a boronic acid group, a boronic acid ester group, a halogen atom, or a perfluoroalkylsulfonyloxy group.

In Formula (LI-4), in a case where Y¹ of Formula (LI-3) is a trialkyl tin group, a boronic acid group, or a boronic acid ester group, Y² represents a halogen atom or a perfluoroalkylsulfonyloxy group, and in a case where Y¹ of Formula (LI-3) is a halogen atom or a perfluoroalkylsulfonyloxy group, Y² represents a trialkyl tin group, a boronic acid group, or a boronic acid ester group.

In Formulae (LI-4) and (LI-5), R represents an alkyl group, an aryl group, or a heteroaryl group.

Specific examples of the ligand LA are shown below. Examples of the ligand LA also include the ligand LA in the metal complex dye which will be described later. Other examples thereof include the compounds in which at least one of -COOH's is formed into a salt of a carboxyl group, with respect to the ligands LA in the following specific examples and the specific examples of the metal complex dye. In these compounds, examples of the counter cation that forms a salt of a carboxyl group include the positive ions described as CI below. Further, examples of the esterified product of the terpyridine compound include the compounds in which at least one of acidic groups is esterified, with respect to the ligands LA in the following specific examples and the specific examples of the metal complex dye. The present invention is not limited to these ligands LA, or salts or esterified products thereof. In the specific examples, Me represents methyl.

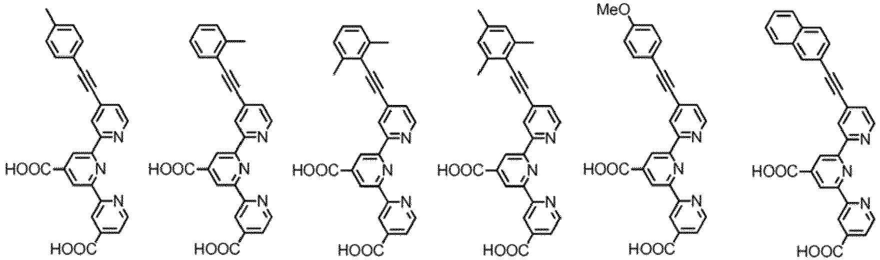

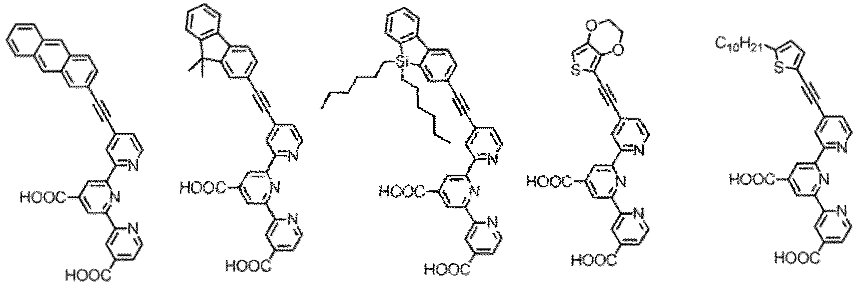

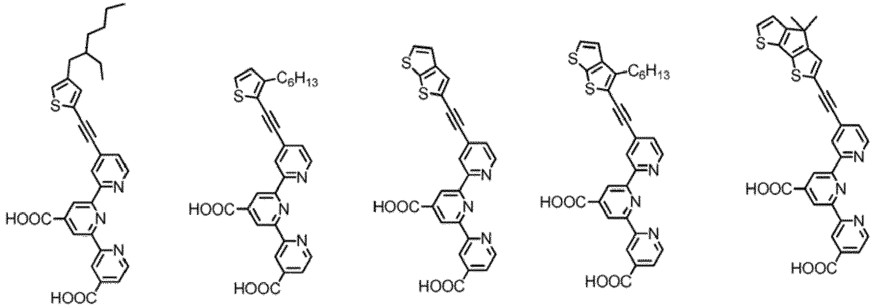

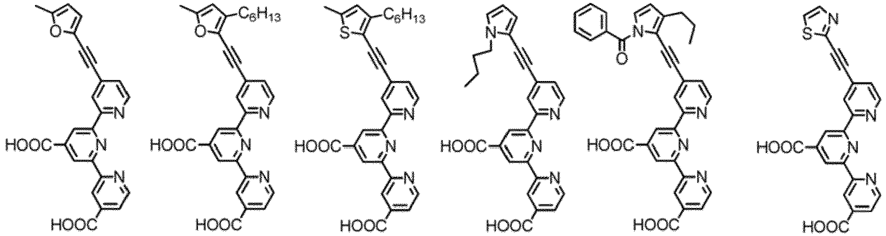

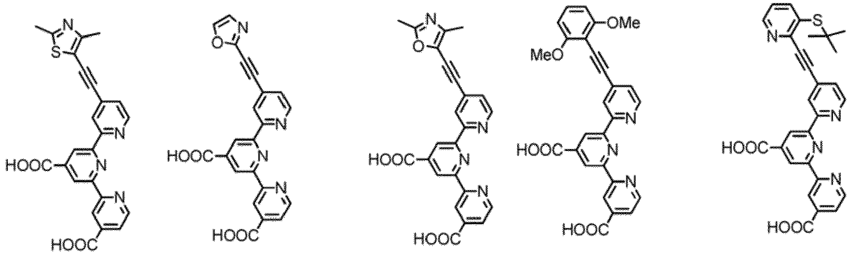

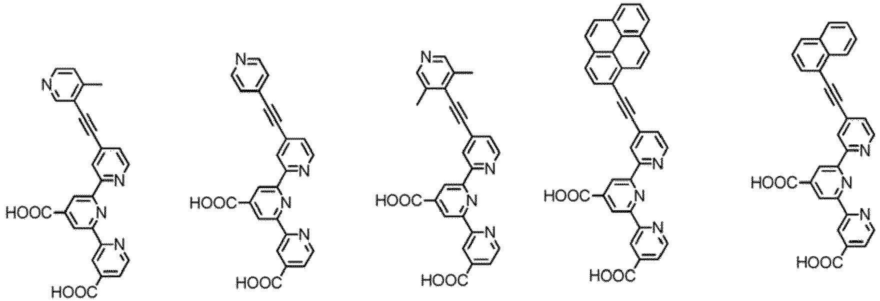

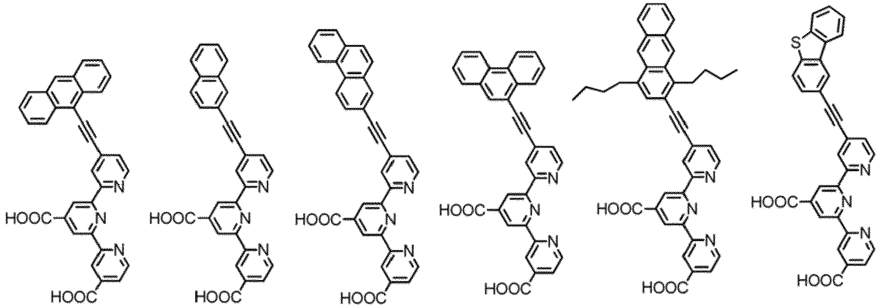

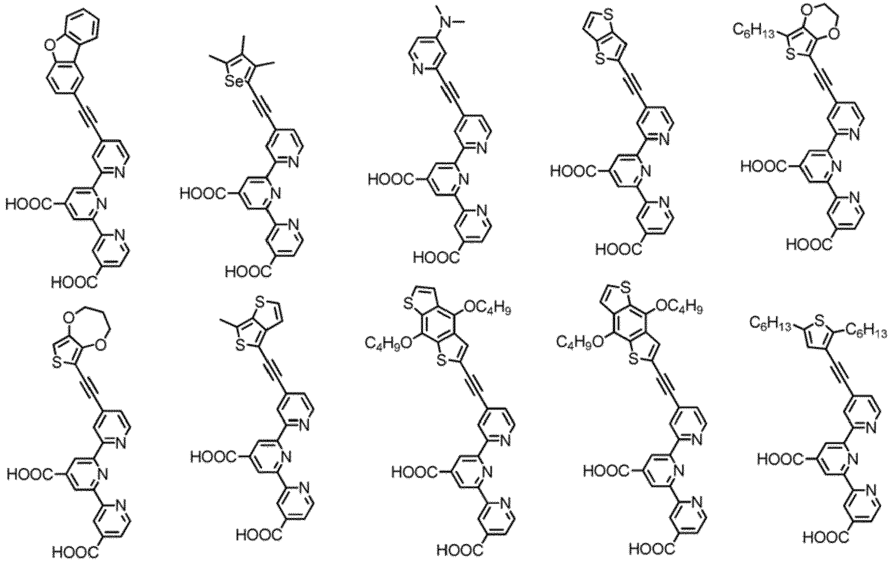

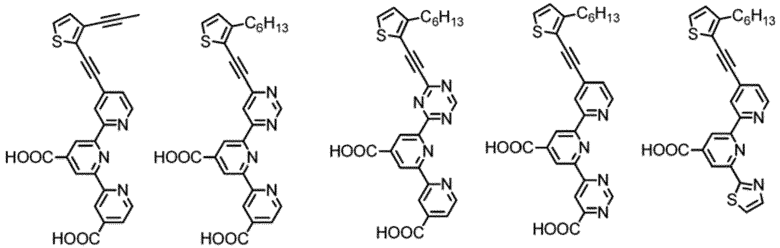

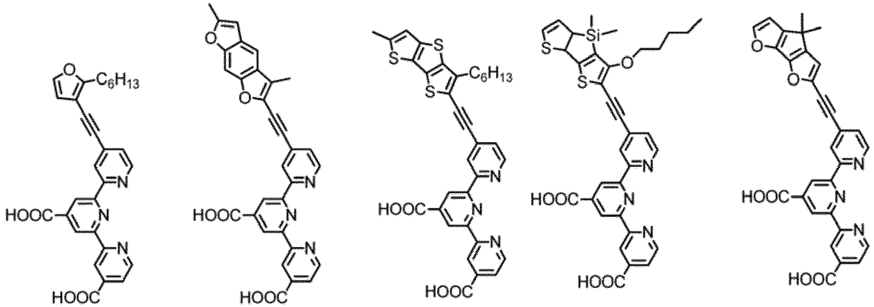

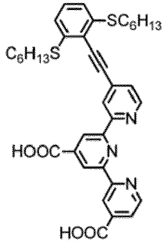

### - Ligand Z -

The ligand Z represents a monodentate ligand or a bidentate ligand.

nZ represents the number of ligands Z, and represents 2 or 3. However, nZ is appropriately determined in consideration of the number (monodentate or bidentate) of coordination sites of the ligand Z such that the total coordination number of "(Z)_{nZ}" is 3. For example, in a case where the ligands Z all coordinate in a monodentate mode, nZ represents 3. In a case where one of the ligands coordinates in a bidentate mode, nZ represents 2 (the remaining ligands coordinate in a monodentate mode). In the present invention, the ligands Z do not necessarily coordinate to metal ions at all the coordination sites, and may coordinate to the metal ion at least one coordination site. For example, even when the ligand is a bidentate ligand, it may coordinate to the metal ion at one coordination site and thus become a monodentate ligand in some cases. Two or three ligands Z may be the same as or different from each other. Incidentally, a plurality of the ligands Z may be bonded to each other.

The ligand Z represents a ligand selected from the group consisting of an acyloxy group, an acylthio group, a thioacyloxy group, a thioacylthio group, an acylaminooxy group, a thiocarbamate group, a dithiocarbamate group, a thiocarbonate group, a dithiocarbonate group, a trithiocarbonate group, an acyl group, a thiocyanate group, an isothiocyanate group, a cyanate group, an isocyanate group, a selenocyanate group, an isoselenocyanate group, a cyano group, an isocyano group, an alkylthio group, an arylthio group, an alkoxy group, an aryloxy group, a halogen atom, carbonyl, dialkylketone, 1,3-diketone, carbonamide, thiocarbonamide, and thiourea.

Here, the ligand selected from the group encompasses an aspect of a monodentate ligand in which each of the above-mentioned groups coordinates to a metal ion (in the form of an anion) and an aspect of a bidentate ligand in which an alkyl group, an aryl group, and the like contained in each of the above-mentioned groups also coordinate to the metal ion. Examples of the bidentate ligand include a picolinic acid compound which is one kind of acyloxy groups. In the picolinic acid compound, the COO group and the ring-constituting nitrogen atom of a pyridine ring can coordinate to metal ions.

The acyloxy group is not particularly limited, but preferably has 1 to 20 carbon atoms and examples thereof include an acetyloxy group, a group having an acyloxy group bonded to a 5- or 6-membered nitrogen-containing ring such as pyridinylcarbonyloxy, a benzoyloxy group, a salicylic acid group, a glycyloxy group, an N,N-dimethylglycyloxy group, and an oxalylene group (-OC(O)C(O)O-). The acylthio group is not particularly limited, but preferably has 1 to 20 carbon atoms and examples thereof include an acetylthio group, a benzoylthio group, and a group having an acylthio group bonded to a 5- or 6-membered nitrogen-containing ring. The thioacylthio group is not particularly limited, but preferably has 1 to 20 carbon atoms and examples thereof include a thioacetyloxy group (CH₃C(S)O-) and a group having a thioacyloxy group bonded to a 5- or 6-membered nitrogen-containing ring. The thioacylthio group is not particularly limited, but preferably has 1 to 20 carbon atoms and examples thereof include a thioacetylthio group (CH₃C(S)S-), a thiobenzoylthio group (PhC(S)S-), and a group having a thioacylthio group bonded to a 5- or 6-membered nitrogen-containing ring. The acylaminooxy group is not particularly limited, but preferably has 1 to 20 carbon atoms and examples thereof include an N-methylbenzoylaminooxy group (PhC(O)N(CH₃)O-) and an acetylaminooxy group (CH₃C(O)NHO-).

The thiocarbamate group is not particularly limited, but preferably has 1 to 20 carbon atoms and examples thereof include an N,N-diethylthiocarbamate group. The dithiocarbamate group is not particularly limited, but preferably has 1 to 20 carbon atoms and examples thereof include an N-phenydithiocarbamate group, an N,N-dimethyldithiocarbamate group, an N,N-diethyldithiocarbamate group, and an N,N-dibenzyldithiocarbamate group. The thiocarbonate group is not particularly limited, but preferably has 1 to 20 carbon atoms and examples thereof include an ethylthiocarbonate group. The dithiocarbonate group is not particularly limited, but preferably has 1 to 20 carbon atoms and examples thereof include an ethyldithiocarbonate group (C₂H₅OC(S)S-). The trithiocarbonate group is not particularly limited, but preferably has 1 to 20 carbon atoms and examples thereof include an ethyltrithiocarbonate group (C₂H₅SC(S)S-). The acyl group is not particularly limited, but preferably has 1 to 20 carbon atoms and examples thereof include an acetyl group and a benzoyl group.

The alkylthio group is not particularly limited, but preferably has 1 to 20 carbon atoms and examples thereof include a methanethio group and an ethylenedithio group. The arylthio group is not particularly limited, but preferably has 6 to 20 carbon atoms and examples thereof include a phenylthio group and a 1,2-phenylenedithio group. The alkoxy group is not particularly limited, but preferably has 1 to 20 carbon atoms and examples thereof include a methoxy group. The aryloxy group is not particularly limited, but preferably has 6 to 20 carbon atoms and examples thereof include a phenoxy group and a quinoline-8-hydroxyl group.

The halogen atom is not particularly limited, but preferred examples thereof include a chlorine atom, a bromine atom, and an iodine atom. Carbonyl is not particularly limited, but examples thereof include ···CO. Dialkylketone is not particularly limited, but preferably has 3 to 20 carbon atoms and examples thereof include acetone ((CH₃)₂CO···).

1,3-Diketone is not particularly limited, but preferably has 3 to 20 carbon atoms and examples thereof include acetylacetone (CH₃C(O···)CH=C(O-)CH₃), trifluoroacetylacetone (CF₃C(O···)CH=C(O-)CH₃), dipivaloylmethane (t-C₄H₉C(O···)CH=C(O-)t-C₄H₉), dibenzoylmethane (PhC(O···)CH=C(O-)Ph), and 3-chloroacetylacetone (CH₃C(O···)CCl=C(O-)CH₃). In the present invention, 1,3-diketone also includes 1,3-diketone having at least one of carbonyl oxygen substituted with a sulfur atom.

Carbonamide is not particularly limited, but preferably has 1 to 20 carbon atoms and examples thereof include CH₃N=C(CH₃)O- and -OC(=NH)-C(=NH)O-. Thiocarbonamide is not particularly limited, but preferably has 1 to 20 carbon atoms and examples thereof include CH₃N=C(CH₃)S-. Thiourea is not particularly limited, but preferably has 1 to 20 carbon atoms and examples thereof include NH(···)=C(S-)NH₂, CH₃N(···)=C(S-)NHCH₃, and (CH₃)₂N-C(S···)N(CH₃)₂.

In the respective ligands, "···" represents a coordination bond with the metal atom M.

Among those, the ligand Z is preferably a ligand selected from the group consisting of a thiocyanate group, an isothiocyanate group, a halogen atom, a cyano group, a cyanate group, an isocyanate group, an alkylthio group, an arylthio group, an alkoxy group, an aryloxy group, ligand represented by Formula (XA-1), and a ligand represented by Formula (XA-2).

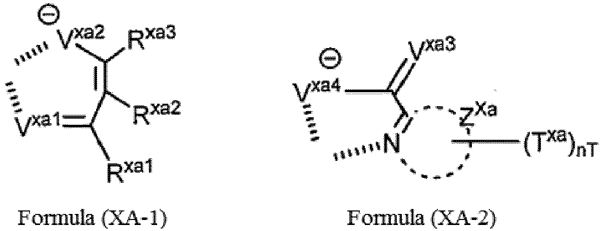

In the formulae, the dotted line represents a bonding moiety to the metal ion M.

V^{xa1} to V^{xa4} each independently represent a sulfur atom or an oxygen atom, with the oxygen atom being preferable.

R^{xa1} to R^{xa3} each independently represent a hydrogen atom or a substituent.

T^{xa} represents a substituent. nT represents an integer of 0 to 4, and is preferably 0 or 1.

The substituent which can be adopted by each of R^{xa1} to R^{xa3} and T^{xa} is not particularly limited, but examples thereof include groups selected from the substituent group T. Among these, R^{xa1} to R^{xa3} are each preferably a group selected from the group consisting of an alkyl group, an aryl group, heterocyclic group, an alkenyl group, an alkynyl group, an amino group, a halogen atom, an alkyl group substituted with a halogen atom (preferably a fluorine atom) (halogenated alkyl group), an aryl group substituted with a halogen atom (preferably a fluorine atom) (halogenated aryl group), and an aryl group substituted with a halogenated alkyl group; or a group formed by the bonding of two or more (preferably two) groups selected from the group. The alkyl group preferably has 1 to 20 carbon atoms. The number of carbon atoms of the alkyl moiety of the halogenated alkyl group is preferably 1 to 30, more preferably 1 to 6, and still more preferably 1, and the alkyl group is particularly preferably a trifluoromethyl group. The halogenated aryl group is preferably a phenyl group substituted with 1 to 5 halogen atoms, more preferably a phenyl group substituted with 1 to 4 halogen atoms, with a phenyl group substituted with one halogen atom being still more preferable. As the aryl group substituted with a halogenated alkyl group, a phenyl group substituted with 1 to 5 halogenated alkyl groups is preferable.

Z^{Xa} represents a non-metal atomic group necessary for completing a 5- or 6-membered ring. Z^{Xa} is preferably a non-metal atomic group selected from a carbon atom, a nitrogen atom, an oxygen atom, a sulfur atom, and a phosphorus atom. The ring formed by Z^{Xa} is preferably an aromatic ring of a 5-membered ring and an aromatic ring of a 6-membered ring. As the aromatic ring of a 5-membered ring and the aromatic ring of a 6-membered ring, the aromatic rings mentioned as the ring formed by Za are preferable. Specifically, the ring formed by Z^{Xa} is preferably at least one selected from the group consisting of a pyridine ring, a pyrimidine ring, a pyrazine ring, a pyridazine ring, a triazine ring, a tetrazine ring, a quinoline ring, an isoquinoline ring, a pyrazole ring, an imidazole ring, a triazole ring, a thiazole ring, an oxazole ring, a benzimidazole ring, a benzotriazole ring, a benzoxazole ring, and a benzothiazole ring. Among these, the ring formed by Z^{Xa} is more preferably a pyridine ring or a pyrimidine ring, and particularly preferably a pyridine ring.

The position to which T^{xa} in the ring formed by Z^{Xa} is bonded is not particularly limited, but examples thereof include 2- to 4-positions with respect to the nitrogen atom within the ring formed by Z^{Xa}, with the 3- or 4-position being preferable.

Among the groups selected from the substituent group T, T^{xa} is preferably an aryl group or heterocyclic group having a substituent, or an amino group, and more preferably a heterocyclic group (heteroaryl group) having aromaticity.

Here, the aryl group and heteroaryl group having a substituent are each a monocycle bonded to the ring formed by Z^{Xa} in Formula (XA-2) or a polycyclic group containing the monocycle as a fused ring, and in a case where the monocycle is a 5-membered ring, it is preferably an aryl group or heteroaryl group having a substituent on at least one of sp² carbon atoms at the α-position with respect to the ring-constituting atom bonded to the ring formed by Z^{Xa}. Further, in a case where the monocycle is a 6-membered ring, it is preferably an aryl group or heteroaryl group having a substituent on at least one of sp² carbon atoms at the α-position and the β-position with respect to the ring-constituting atom bonded to the ring formed by Z^{Xa}. Such the aryl group and heteroaryl group have the same definition as the above-mentioned R^{V3} having a substituent, and preferred examples thereof are also the same. T^{xa} is more preferably a group represented by Formula (V-1) in R^{V3}.

Examples of the amino group include the amino groups described in the substituent group T which will be described later.

Examples of the ligand represented by Formula (XA-1) include the preferred aspects of 1,3-diketone. In addition to these, other examples of the ligand represented by the formula include those having at least one of carbonyl oxygen in 1,3-diketone substituted with a sulfur atom, and include, for example, an aspect in which V^{xa1} is an oxygen atom and V^{xa2} is a sulfur atom, an aspect in which V^{xa1} is a sulfur atom and V^{xa2} is an oxygen atom, or an aspect (thioacylthio group) in which V^{xa1} is a sulfur atom and V^{xa2} is a sulfur atom.

Examples of the ligand represented by Formula (XA-2) include the preferred aspects of the acyloxy group. In addition to these, other examples of the ligand represented by the formula include an aspect (thioacylthio group) in which V^{xa3} is a sulfur atom and V^{xa4} is a sulfur atom.

The ligand Z is more preferably an isothiocyanate group, a ligand represented by Formula (XA-1b), or a ligand represented by Formula (XA-2b).

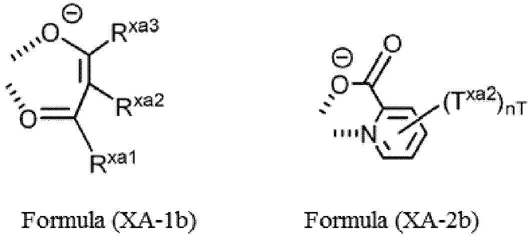

In the formulae, the dotted line represents a bonding moiety to the metal ion M. R^{xa1} to R^{xa3} each independently represent a hydrogen atom or a substituent. T^{xa2} represents a substituent and nT represents an integer of 0 to 4. R^{xa1} to R^{xa3}, T^{xa2}, and nT have the same definitions as R^{xa1} to R^{xa3}, T^{xa}, and nT, respectively, in Formulae (XA-1) and (XA-2), and preferred examples thereof are also the same.

In addition to those described above, other examples of the ligand represented by Formula (XA-1b) include the ligands shown below and the ligands shown in the exemplification of a metal complex dye and Examples below, but the present invention is not limited to these ligands.

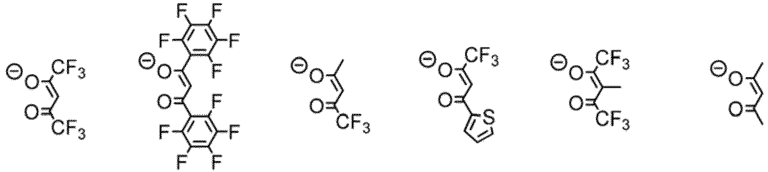

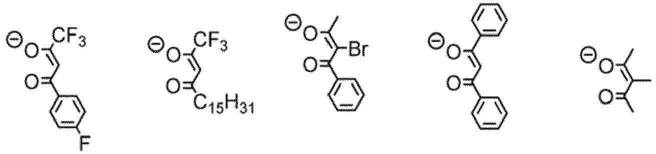

In addition to those described above, other examples of the ligand represented by Formula (XA-2b) include the ligands shown below and the ligands shown in the exemplification of a metal complex dye and Examples below, but the present invention is not limited to these ligands. In each of the ligands shown below, the wavy line represents a bonding moiety (the oxygen atom of a carboxyl group and the ring-constituting nitrogen atom of a pyridine ring) to the metal ion M.

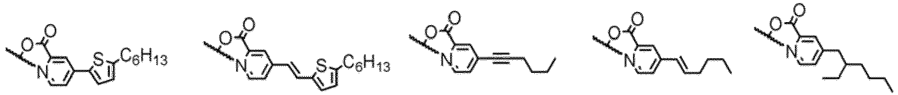

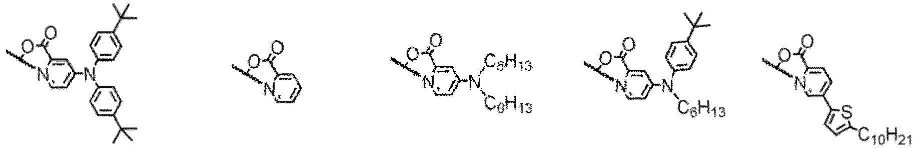

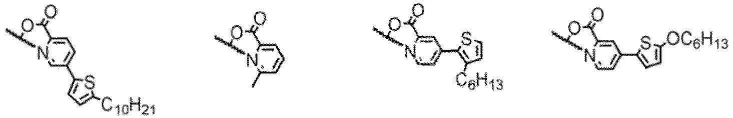

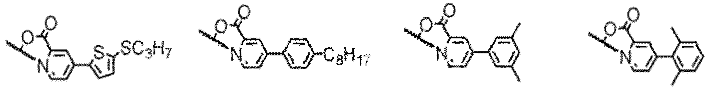

In a case where the ligands Z are two or more different kinds of ligands, a combination thereof is not particularly limited. Preferably, examples of the combination include combinations of the ligands contained in the specific examples of the metal complex dyes which will be described later or the metal complex dyes used in Examples.

In a case where the ligands Z contain an alkyl group, an alkenyl group, an alkynyl group, an alkylene group, or the like, they may be linear or branched, or may be substituted. Further, in a case where the ligands Z contain an aryl group, a heterocyclic group, a cycloalkyl group, or the like, they may be substituted, or may be a monocycle or a fused ring.

As the ligand Z, a commercially available product can also be used and can also be appropriately synthesized.

For example, the picolinic acid derivative among the ligand represented by (XA-2) can be synthesized by, for example, the following scheme, in accordance with the synthesis method for the compound No. 45 described in Journal of Medicinal Chemistry, 2011, vol. 54, No. 13, pp. 4721-4734.

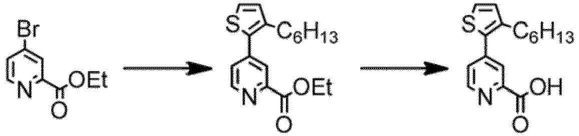

In addition to the ligand represented by Formula (XA-1b) or (XA-2b), specific examples of the ligand Z are shown below. Further, other examples of the ligand Z include the ligands Z in the metal complex dyes which will be described later. The present invention is not limited to these ligands Z.

The structural formulae shown below are merely one canonical structure among the resonance structures that can be taken in plural numbers, and the covalent bond (represented by -) and the coordination bond (represented by ···) are also formally distinguished without any absolute distinction.

| | | | | | | | |
|---|---|---|---|---|---|---|---|
| Z-1 | 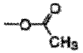 | Z-2 | 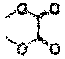 | Z-9 | 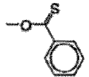 | Z-10 | 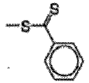 |
| Z-3 | 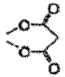 | Z-4 | 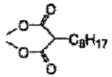 | Z-11 | 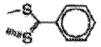 | Z-12 | 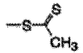 |
| Z-5 | 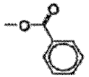 | Z-6 | 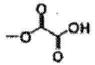 | Z-13 | 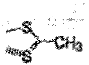 | Z-14 | 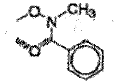 |
| Z-7 | 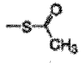 | Z-8 | 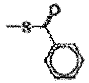 | Z-15 | 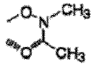 | Z-16 | 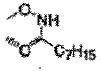 |
| Z-17 | 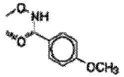 | Z-18 | 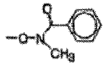 | Z-25 | 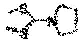 | Z-26 | 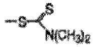 |
| Z-19 | 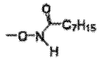 | Z-20 | 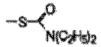 | Z-27 | 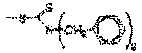 | Z-28 | 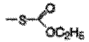 |
| Z-21 | 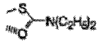 | Z-22 | 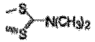 | Z-29 | 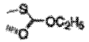 | Z-30 | 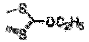 |
| Z-23 | 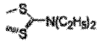 | Z-24 | 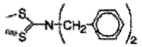 | Z-31 | 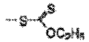 | Z-32 | 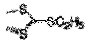 |

| | | | | | | | |
|---|---|---|---|---|---|---|---|
| Z-33 | 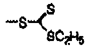 | Z-34 | 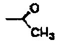 | Z-51 | -CN Z-52 | -NC | Z-53 -SCH₃ |
| Z-35 | 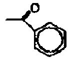 | Z-36 | -CO | Z-54 | 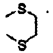 | Z-55 | 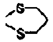 |
| Z-37 | 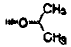 | Z 38 | 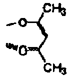 | Z-56 | 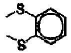 | Z-57 | --S(CH₂)₂SH |
| Z-39 | 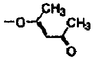 | Z-40 | 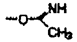 | Z-58 | -S(CH₂)₃SH | Z-59 | 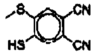 |
| Z-41 | 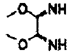 | Z-42 | -NCSe | Z-60 | -OCH₃ | Z-61 | 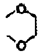 |
| Z-43 | -SeCN | Z-44 | -NCS | Z-62 | 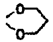 | Z-63 | 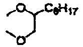 |
| Z-45 | -SCN | Z-46 | -NCO | Z-64 | 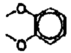 | Z-65 | 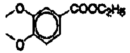 |
| Z-47 | -OCN | Z-48 | -Cl | | | | |
| Z-49 | -Br | Z-50 | -I | Z-66 | 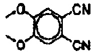 | Z-67 | 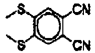 |
| Z-68 | 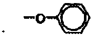 | Z-69 | 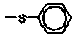 | | | | |
| Z-70 | 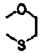 | Z-71 | 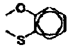 | | | | |
| Z-72 | -O(CH₂)₂OH | Z-73 | -O(CH₂)₃OH | | | | |
| Z-74 | 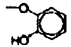 | Z-75 | 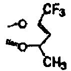 | | | | |
| Z-76 | 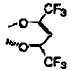 | Z-77 | 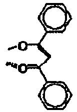 | | | | |
| Z-78 | 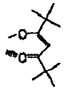 | Z-79 | 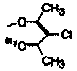 | Z-84 | 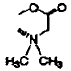 | Z-85 | 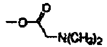 |
| Z-80 | 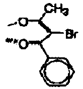 | Z-81 | 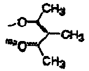 | Z-86 | 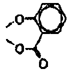 | Z-87 | 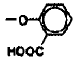 |
| | | | | Z-88 | 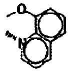 | Z-89 | 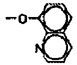 |
| Z-82 | 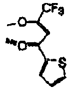 | Z-83 | 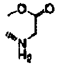 | Z-90 | 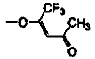 | | |

### - Counterion CI for Neutralizing Charge -

CI represents a counterion when the counterion is necessary for neutralizing the charge. Generally, whether the metal complex dye is cationic or anionic, or whether the metal complex dye has a net ionic charge depends on the metal, the ligand, and the substituent in the metal complex dye.

When the substituent has a dissociative group or the like, the metal complex dye may have a negative charge arising from dissociation. In this case, an electric charge of the metal complex dye as a whole is electrically neutralized by CI.

In a case where the counterion CI is a positive counterion, the counterion CI is, for example, an inorganic or organic ammonium ion (for example, a tetraalkyl ammonium ion and a pyridinium ion), a phosphonium ion (for example, a tetraalkylphosphonium ion and an alkyltriphenylphosphonium ion), an alkali metal ion (a Li ion, an Na ion, a K ion, and the like), an alkaline earth metal ion, a metal complex ion, or a proton. As the positive counterion, an inorganic or organic ammonium ion (a tetraethylammonium ion, a tetrabutylammonium ion, a tetrahexylammonium ion, a tetraoctylammonium ion, a tetradecylammonium ion, and the like), an alkali metal ion, and a proton are preferable.

In a case where the counterion CI is a negative counterion, the counterion CI is, for example, an inorganic anion or an organic anion. Examples thereof include a hydroxide ion, a halogen anion (for example, a fluoride ion, a chloride ion, a bromide ion, and an iodide ion), a substituted or unsubstituted alkylcarboxylate ion (for example, an acetate ion and a trifluoroacetate ion), a substituted or unsubstituted arylcarboxylate ion (for example, a benzoate ion), a substituted or unsubstituted alkylsulfonate ion (for example, a methanesulfonate ion and a trifluoromethanesulfonate ion), a substituted or unsubstituted arylsulfonate ion (for example, a p-toluene sulfonate ion and a p-chlorobenzene sulfonate ion), an aryldisulfonate ion (for example, a 1,3-benzene disulfonate ion, a 1,5-naphthalene disulfonate ion, and a 2,6-naphthalene disulfonate ion), an alkylsulfate ion (for example, a methylsulfate ion), a sulfate ion, a thiocyanate ion, a perchlorate ion, a tetrafluoroborate ion, a hexafluorophosphate ion, and a picrate ion. Alternatively, as a charge balance counterion, an ionic polymer or another dye with an opposite charge from the dye in interest may be used, or a metal complex ion (for example, a bisbenzene-1,2-dithiolatonickel (III)) may also be used. As the negative counterion, a halogen anion, a substituted or unsubstituted alkylcarboxylate ion, a substituted or unsubstituted alkylsulfonate ion, a substituted or unsubstituted arylsulfonate ion, an aryldisulfonate ion, a perchlorate ion, and a hexafluorophosphate ion are preferable, and a halogen anion and a hexafluorophosphate ion are more preferable.

### - Metal Complex Dye -

The metal complex dye of the present invention is represented by Formula (1).

In the metal complex dye of the present invention, the ligand LA and the ligand Z are as described above, and the combination of these ligands is not particularly limited. A preferred combination of the ligands is a combination of the preferred ligand LA and the preferred ligand Z.

The metal complex dye can be synthesized by, for example, the method described in JP2013-084594A, the method described in JP4298799B, the method described in each specification of US2013/0018189A1, US2012/0073660A1, US2012/0111410A1, and US2010/0258175A1, the method described in Angew. Chem. Int. Ed., 2011, 50, 2054-2058, the methods described in the reference documents listed in these documents, the patent documents regarding solar cells, known methods, or the methods equivalent thereto.

The metal complex dye represented by Formula (1) has a maximum absorption wavelength in a solution, preferably in a range from 300 to 1,000 nm, more preferably in a range from 350 to 950 nm, and particularly preferably in a range from 370 to 900 nm.

### <Substituent Group T>

In the present invention, preferred examples of the substituent include the groups selected from the following substituent group T.

Incidentally, in the present specification, in a case where there is only a simple description of a substituent, reference is made to this substituent group T, and further, in a case where each of the groups, for example, an alkyl group is merely described, preferable ranges and specific examples for the corresponding group for the substituent group T are applied.

In the present specification, in a case where an alkyl group is described as separate from a cycloalkyl group, the alkyl group is used to mean inclusion of both of a linear alkyl group and a branched alkyl group. On the other hand, in a case where an alkyl group is not described as separate from a cycloalkyl group (a case where an alkyl group is simply described), and unless otherwise specified, the alkyl group is used to mean inclusion of both of a linear alkyl group, a branched alkyl group, and a cycloalkyl group. This shall apply to a group (an alkoxy group, an alkylthio group, an alkenyloxy group, and the like) including a group (an alkyl group, an alkenyl group, an alkynyl group, and the like) which can adopt a cyclic structure, and a compound (the alkyl esterified product and the like) including a group which can adopt a cyclic structure. In the following description of the substituent group T, for example, a group with a linear or branched structure and a group with a cyclic structure may be sometimes separately described for clarification of both groups, as in the alkyl group and the cycloalkyl group.

Examples of the groups included in the substituent group T include the following groups or the groups formed by the combination of a plurality of the following groups:
an alkyl group (preferably an alkyl group having 1 to 20 carbon atoms, and more preferably an alkyl group having 1 to 12 carbon atoms, for example, methyl, ethyl, isopropyl, t-butyl, pentyl, heptyl, 1-ethylpentyl, benzyl, 2-ethoxyethyl, 1-carboxymethyl, and trifluoromethyl), an alkenyl group (preferably an alkenyl group having 2 to 20 carbon atoms, and more preferably an alkenyl group having 1 to 12 carbon atoms, for example, vinyl, allyl, and oleyl), an alkynyl group (preferably an alkynyl group having 2 to 20 carbon atoms, and more preferably an alkynyl group having 1 to 12 carbon atoms, for example, ethynyl, butynyl, and phenylethynyl), a cycloalkyl group (preferably a cycloalkyl group having 3 to 20 carbon atoms,), an cycloalkenyl group (preferably a cycloalkenyl group having 5 to 20 carbon atoms), an aryl group (preferably an aryl group having 6 to 26 carbon atoms, for example, phenyl, 1-naphthyl, 4-methoxyphenyl, 2-chlorophenyl, 3-methylphenyl, difluorophenyl, and tetrafluorophenyl), a heterocyclic group (preferably a heterocyclic group having 2 to 20 carbon atoms, and more preferably a 5- or 6-membered heterocyclic group having at least one oxygen atom, sulfur atom, or nitrogen atom. The heterocycle encompasses an aromatic ring and an aliphatic ring. Examples of the aromatic heterocyclic group (for example, a heteroaryl group) include the following groups: for example, 2-pyridyl, 4-pyridyl, 2-imidazolyl, 2-benzimidazolyl, 2-thiazolyl, and 2-oxazolyl), an alkoxy group (preferably an alkoxy group having 1 to 20 carbon atoms, and more preferably an alkoxy group having 1 to 12 carbon atoms, for example, methoxy, ethoxy, isopropyloxy, and benzyloxy), an alkenyloxy group (preferably an alkenyloxy group having 2 to 20 carbon atoms, and more preferably an alkenyloxy group having 1 to 12 carbon atoms), an alkynyloxy group (preferably an alkynyloxy group having 2 to 20 carbon atoms, and more preferably an alkynyloxy group having 1 to 12 carbon atoms), a cycloalkyloxy group (preferably a cycloalkyloxy group having 3 to 20 carbon atoms), an aryloxy group (preferably an aryloxy group having 6 to 26 carbon atoms), a heterocyclic oxy group (preferably a heterocyclic oxy group having 2 to 20 carbon atoms),
an alkoxycarbonyl group (preferably an alkoxycarbonyl group having 2 to 20 carbon atoms), a cycloalkoxycarbonyl group (preferably a cycloalkoxycarbonyl group having 4 to 20 carbon atoms), an aryloxycarbonyl group (preferably an aryloxycarbonyl group having 6 to 20 carbon atoms), an amino group (preferably an amino group having 0 to 20 carbon atoms, including an alkylamino group, an alkenylamino group, an alkynylamino group, a cycloalkylamino group, a cycloalkenylamino group, an arylamino group, and a heterocyclic amino group, for example, amino, N,N-dimethylamino, N,N-diethylamino, N-ethylamino, N-allylamino, N-(2-propynyl)amino, N-cyclohexylamino, N-cyclohexenylamino, anilino, pyridylamino, imidazolylamino, benzimidazolylamino, thiazolylamino, benzothiazolylamino, and triazinylamino), a sulfamoyl group (preferably a sulfamoyl group having 0 to 20 carbon atoms, preferably an alkyl-, cycloalkyl-, and aryl-sulfamoyl group), an acyl group (preferably an acyl group having 1 to 20 carbon atoms), an acyloxy group (preferably an acyloxy group having 1 to 20 carbon atoms), a carbamoyl group (preferably a carbamoyl group having 1 to 20 carbon atoms, preferably alkyl-, cycloalkyl-, and aryl-carbamoyl groups),
an acylamino group (preferably an acylamino group having 1 to 20 carbon atoms), a sulfonamido group (preferably a sulfonamido group having 0 to 20 carbon atoms, preferably alkyl-, cycloalkyl-, and aryl-sulfonamido groups), an alkylthio group (preferably an alkylthio group having 1 to 20 carbon atoms, and more preferably an alkylthio group having 1 to 12 carbon atoms, for example, methylthio, ethylthio, isopropylthio, and benzylthio), a cycloalkylthio group (preferably a cycloalkylthio group having 3 to 20 carbon atoms), an arylthio group (preferably an arylthio group having 6 to 26 carbon atoms), an alkyl-, cycloalkyl-, and aryl-sulfonyl group (preferably a sulfonyl group having 1 to 20 carbon atoms),
a silyl group (preferably a silyl group having 1 to 20 carbon atoms, preferably alkyl-, aryl-, alkoxy-, and aryloxy-substituted silyl groups), a silyloxy group (preferably a silyloxy group having 1 to 20 carbon atoms, preferably alkyl-, aryl-, alkoxy-, and aryloxy-substituted silyloxy groups), a hydroxyl group, a cyano group, a nitro group, a halogen atom (for example, a fluorine atom, a chlorine atom, a bromine atom, and iodine atom), a carboxyl group, a sulfo group, a phosphonyl group, a phosphoryl group, and a boric acid group.

Examples of the group selected from the substituent group T more preferably include an alkyl group, an alkenyl group, a cycloalkyl group, an aryl group, a heterocyclic group, an alkoxy group, a cycloalkoxy group, an aryloxy group, an alkoxycarbonyl group, a cycloalkoxycarbonyl group, an amino group, an acylamino group, a cyano group, and a halogen atom, and particularly preferably include an alkyl group, an alkenyl group, a heterocyclic group, an alkoxy group, an alkoxycarbonyl group, an amino group, an acylamino group, and a cyano group.

In a case where the compound, the substituent, or the like includes an alkyl group, an alkenyl group, or the like, these may be substituted or unsubstituted. Incidentally, in a case where the compound, the substituent, or the like includes an aryl group, a heterocyclic group, or the like, these may be a monocycle or a fused ring, and may be substituted or unsubstituted.

Specific examples of the metal complex dye represented by Formula (1) are shown in the following description (including Examples). Further, the specific examples in the following description and the specific examples in Examples also include metal complex dyes in which at least one of -COOH's is formed into a salt of the carboxyl group. In these metal complex dyes, examples of the counter cation that forms a salt of a carboxyl group include the positive ions described for the CI. The present invention is not limited to these metal complex dyes. In a case where these metal complex dyes have optical isomers or geometric isomers, the metal complex dye may be any of these isomers or a mixture of these isomers.

The following specific examples each independently represent the specific examples of each of the ligands LA and Z, irrespective of the specific combinations of the ligands LA and Z in the respective specific examples.

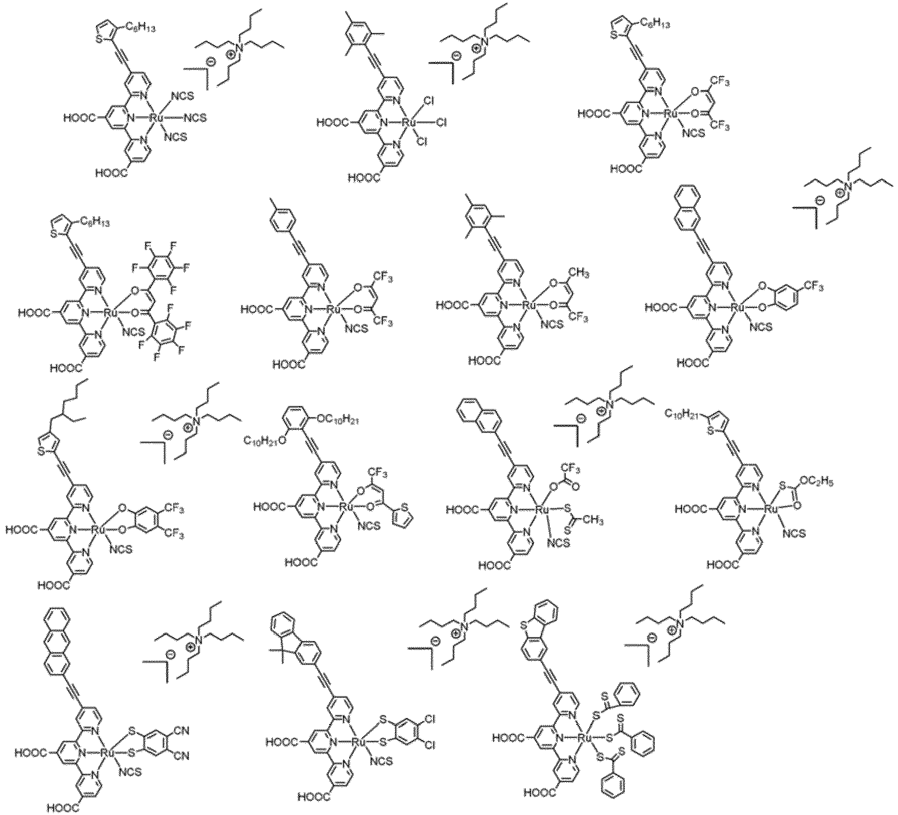

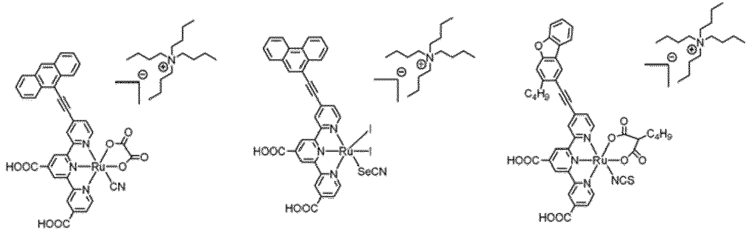

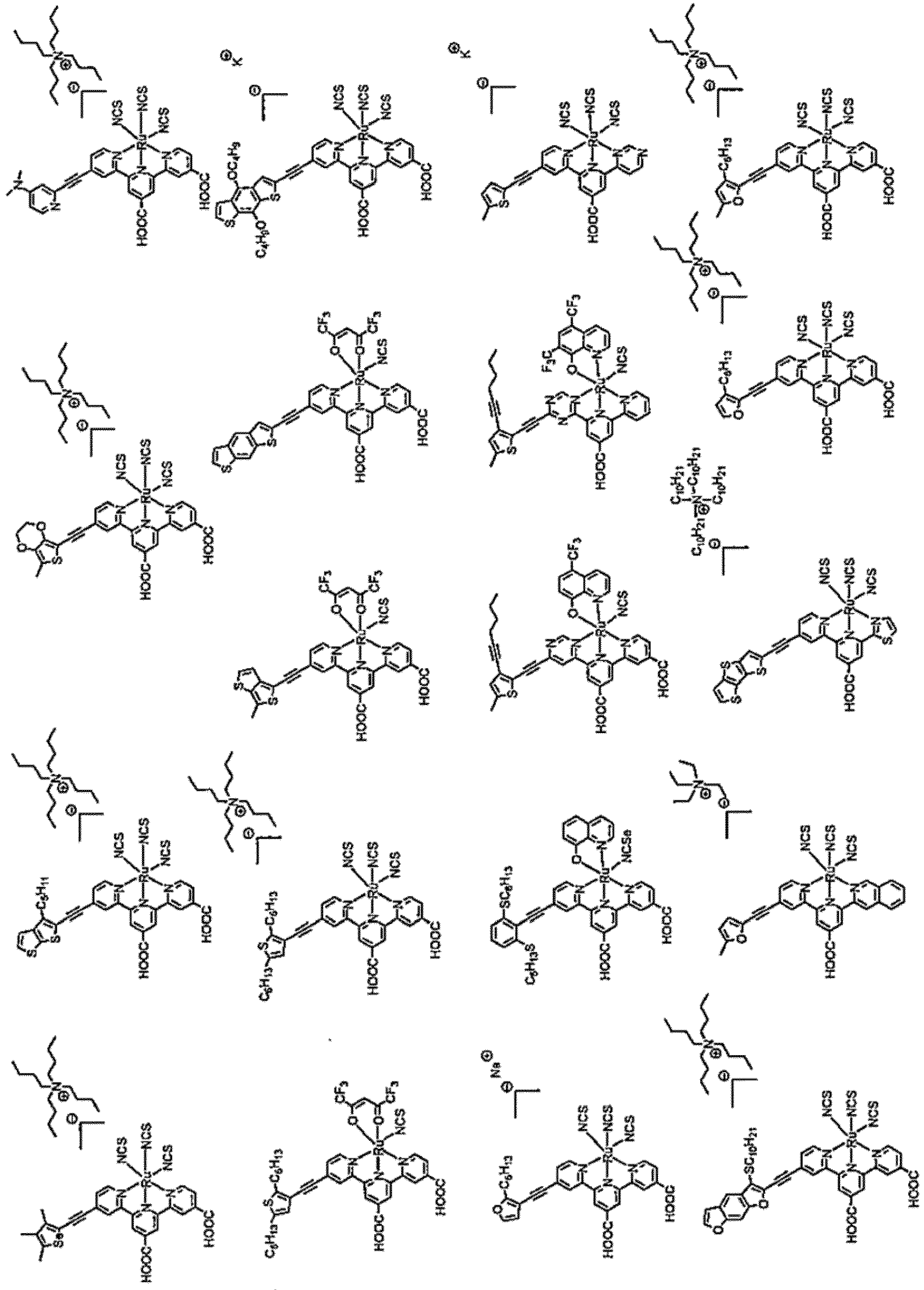

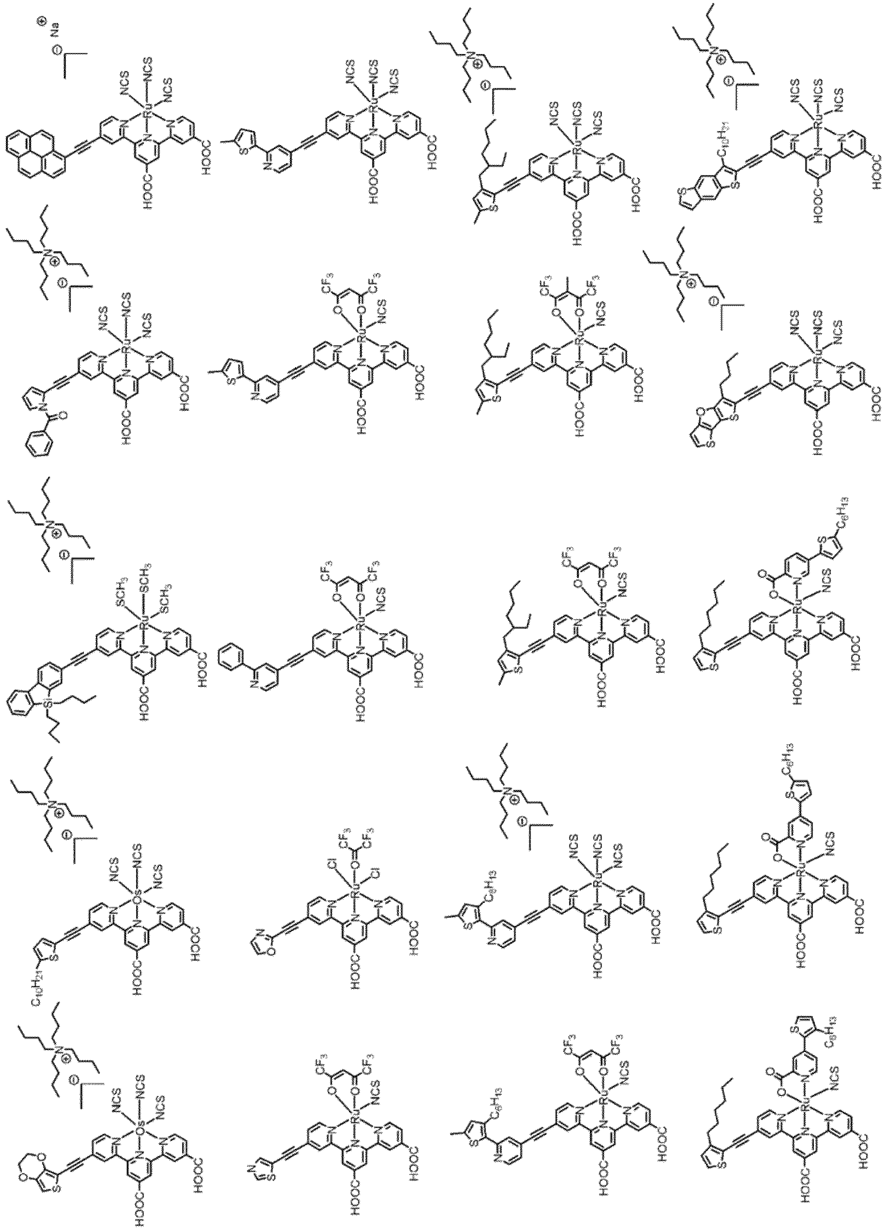

Next, preferred aspects of the main members of the photoelectric conversion element and the dye-sensitized solar cell will be described.

### <Electrically Conductive Support>

The electrically conductive support is not particularly limited as long as it has electrical conductivity and is capable of supporting a photoconductor layer 2 or the like. The electrically conductive support is preferably an electrically conductive support 1 formed of a material having conductivity, such as a metal, or an electrically conductive support 41 having a glass or plastic substrate 44 and a transparent electrically-conductive film 43 formed on the surface of the substrate 44.

Among them, the electrically conductive support 41 having the transparent electrically-conductive film 43 of a metal oxide on the surface of the substrate 44 is more preferable. Such the electrically conductive support 41 is obtained by applying an electrically conductive metal oxide onto the surface of the substrate 44 to form a transparent electrically-conductive film 43. Examples of the substrate 44 formed of plastics include the transparent polymer films described in paragraph No. 0153 of JP2001-291534A. Further, as a material which forms the substrate 44, ceramics (JP2005-135902A) or electrically conductive resins (JP2001-160425A) can be used, in addition to glass and plastics. As the metal oxide, tin oxide (TO) is preferable, and indium-tin oxide (tin-doped indium oxide; ITO), and fluorine-doped tin oxide such as tin oxide which has been doped with fluorine (FTO) are particularly preferable. In this case, the coating amount of the metal oxide is preferably 0.1 to 100 g, per square meter of the surface area of the substrate 44. In a case of using the electrically conductive support 41, it is preferable that light is incident from the substrate 44.

It is preferable that the electrically conductive supports 1 and 41 are substantially transparent. The expression, "substantially transparent", means that the transmittance of light (at a wavelength of 300 to 1,200 nm) is 10% or more, preferably 50% or more, and particularly preferably 80% or more.

The thickness of the electrically conductive supports 1 and 41 is not particularly limited, but is preferably 0.05 µm to 10 mm, more preferably 0.1 µm to 5 mm, and particularly preferably 0.3 µm to 4 mm.

In a case of having a transparent electrically-conductive film 43, the thickness of the transparent electrically-conductive film 43 is preferably 0.01 to 30 µm, more preferably 0.03 to 25 µm, and particularly preferably 0.05 to 20 µm.

The electrically conductive supports 1 and 41 may be provided with a light management function at the surface, and may have, for example, the anti-reflection film having a high refractive index film and a low refractive index oxide film alternately laminated described in JP2003-123859A, and the light guide function described in JP2002-260746A on the surface.

### <Photoconductor Layer>

As long as the photoconductor layer has semiconductor fine particles 22 carrying the dye 21 and an electrolyte, it is not particularly limited in terms of other configurations. Preferred examples thereof include the photoconductor layer 2 and the photoconductor layer 42.

### - Semiconductor Fine Particles (Layer Formed by Semiconductor Fine Particles) -

The semiconductor fine particles 22 are preferably fine particles of chalcogenides of metals (for example, oxides, sulfides, and selenides) or of compounds having perovskite type crystal structures. Preferred examples of the chalcogenides of metals include oxides of titanium, tin, zinc, tungsten, zirconium, hafnium, strontium, indium, cerium, yttrium, lanthanum, vanadium, niobium, or tantalum, cadmium sulfide, and cadmium selenide. Preferred examples of the compounds having perovskite type crystal structures include strontium titanate and calcium titanate. Among these, titanium oxide (titania), zinc oxide, tin oxide, and tungsten oxide are particularly preferable.

Examples of the crystal structure of titania include structures of an anatase type, a brookite type, and a rutile type, with the structures of an anatase type and a brookite type being preferable. A titania nanotube, nanowire, or nanorod may be used singly or in mixture with titania fine particles.

The particle diameter of the semiconductor fine particles 22 is expressed in terms of an average particle diameter using a diameter when a projected area is converted into a circle, and is preferably 0.001 to 1 µm as primary particles, and 0.01 to 100 µm as an average particle diameter of dispersions. Examples of the method for coating the semiconductor fine particles 22 on the electrically conductive supports 1 or 41 include a wet method, a dry method, and other methods.

It is preferable that the semiconductor fine particles 22 have a large surface area so that they may adsorb a large amount of the dye 21. For example, in a state where the semiconductor fine particles 22 are coated on the electrically conductive support 1 or 41, the surface area is preferably 10 times or more, and more preferably 100 times or more, with respect to the projected area. The upper limit of this value is not particularly limited, and the upper limit is usually about 5,000 times. In general, as the thickness of the layer (photoconductor layer) formed by the semiconductor fine particles increases, the amount of the dye 21 that can be carried per unit area increases, and therefore, the light absorption efficiency increases. However, since the diffusion distance of generated electrons increases correspondingly, the loss due to charge recombination also increases.

As described above, it can be expected that in the photoelectric conversion element and the dye-sensitized solar cell, as the diffusion distance of excited electrons is smaller, the electron transport efficiency more increases. However, when the thickness of the layer formed by the semiconductor fine particles is decreased, the photoelectric conversion efficiency may be reduced in some cases. The photoelectric conversion element and the dye-sensitized solar cell of the present invention have the metal complex dye of the present invention, which uses a combination of the ligand LA and the ligand Z. Thus, even in a case where the layer formed by the semiconductor fine particles has the same thickness as that the related art or has a smaller thickness than that in the related art, excellent photoelectric conversion efficiency is exerted. Thus, according to the present invention, the effect of the film thickness of the layer formed by the semiconductor fine particles is little and excellent photoelectric conversion efficiency is exerted.

Although a preferred thickness of the layer formed by the semiconductor fine particles may vary depending on the utility of the photoelectric conversion element, the thickness is typically 0.1 to 100 µm. In a case of using the photoelectric conversion element as a dye-sensitized solar cell, the thickness of the layer is more preferably 1 to 50 µm, and still more preferably 3 to 30 µm.

In the present invention, by using the metal complex dye represented by Formula (1), the thickness of the layer formed by the semiconductor fine particles can be reduced. For example, among the preferred ranges, the thickness can be adjusted to 8 µm or less, and to 6 µm or less.

It is preferable that the semiconductor fine particles 22 may be calcined at a temperature of 100°C to 800°C for 10 minutes to 10 hours after being applied on the electrically conductive support 1 or 41, so as to bring about cohesion of the particles. In a case of using glass as a material for the electrically conductive support 1 or the substrate 44 is used, the temperature is preferably 60°C to 600°C.

The coating amount of the semiconductor fine particles 22 per square meter of the surface area of the electrically conductive support 1 or 41 is preferably 0.5 to 500 g, and more preferably 5 to 100 g.

### - Light-Scattering Layer -

In the present invention, the light-scattering layer is different from the semiconductor layer 45 in that the light-scattering layer has a function of scattering incident light.

In the dye-sensitized solar cell 20, the light-scattering layer 46 preferably contains rod-shaped or plate-shaped metal oxide fine particles. Examples of the metal oxide to be used in the light-scattering layer 46 include the chalcogenides (oxides) of the metals, described as the compound that forms the semiconductor fine particles. In a case of providing the light-scattering layer 46, it is preferable that the thickness of the light-scattering layer is set to 10% to 50% of the thickness of the photoconductor layer.

The light-scattering layer 46 is preferably the light-scattering layer described in JP2002-289274A, and the description of JP2002-289274A is preferably incorporated herein by reference.

It is preferable that a short circuit-preventing layer is formed between the electrically conductive support 1 or 41 and the photoconductor layer 2 or 42 so as to prevent reverse current due to a direct contact between the electrolyte included in the photoconductor layer 2 or 42 and the electrically conductive support 1 or 41.

In addition, it is preferable to use a spacer S (see Fig. 2) or a separator, so as to prevent contact between the light-receiving electrode 5 or 40 and the counter electrode 4 or 48.

### - Dye -

In the photoelectric conversion element 10 and the dye-sensitized solar cell 20, at least one kind of metal complex dye represented by Formula (1) is used as a sensitizing dye. The metal complex dye represented by Formula (1) is as described above.

In the present invention, examples of the dye that can be used in combination with the metal complex dye of Formula (1) include a Ru complex dye, a squarylium cyanine dye, an organic dye, a porphyrin dye, and a phthalocyanine dye.

As the dye to be used in combination, Ru complex dyes, squarylium cyanine dyes, or organic dyes are preferable.

The overall amount of the dye to be used is preferably 0.01 to 100 millimoles, more preferably 0.1 to 50 millimoles, and particularly preferably 0.1 to 10 millimoles, per square meter of the surface area of the electrically conductive support 1 or 41. Further, the amount of the dye 21 to be adsorbed onto the semiconductor fine particles 22 is preferably 0.001 to 1 millimole, and more preferably 0.1 to 0.5 millimoles, with respect to 1 g of the semiconductor fine particles 22. By setting the amount of the dye to such a range, the sensitization effect on the semiconductor fine particles 22 is sufficiently obtained.

In a case where the metal complex dye represented by Formula (1) is used in combination with another dye, the ratio of the mass of the metal complex dye represented by Formula (1)/the mass of another dye is preferably 95/5 to 10/90, more preferably 95/5 to 50/50, still more preferably 95/5 to 60/40, particularly preferably 95/5 to 65/35, and most preferably 95/5 to 70/30.

After the dye is carried on the semiconductor fine particles 22, the surface of the semiconductor fine particles 22 may be treated using an amine compound. Preferred examples of the amine compound include pyridine compounds (for example, 4-t-butylpyridine and polyvinylpyridine). These may be used as they are in a case where they are liquids, or may be used in a state where they are dissolved in an organic solvent.

### - Co-Adsorbent -

In the present invention, it is preferable to use a co-adsorbent together with the metal complex dye represented by Formula (1) or with another dye to be used in combination, if necessary. Such a co-adsorbent which includes a co-adsorbent having at least one acidic group (preferably a carboxyl group or a salt thereof) is preferable, and examples thereof include a fatty acid and a compound having a steroid skeleton.

The fatty acid may be a saturated fatty acid or an unsaturated fatty acid, and examples thereof include butanoic acid, hexanoic acid, octanoic acid, decanoic acid, hexadecanoic acid, dodecanoic acid, palmitic acid, stearic acid, oleic acid, linoleic acid, and linolenic acid.

Examples of the compound having a steroid skeleton include cholic acid, glycocholic acid, chenodeoxycholic acid, hyocholic acid, deoxycholic acid, lithocholic acid, and ursodeoxycholic acid, among which cholic acid, deoxycholic acid, and chenodeoxycholic acid are preferable; and deoxycholic acid are more preferable.

Preferred examples of the co-adsorbents include the compounds represented by Formula (CA) described in paragraph Nos. 0125 to 0129 of JP2014-82187A, and the description of paragraph Nos. 0125 to 0129 of JP2014-82187A are preferably incorporated herein by reference.

By making the co-adsorbent adsorbed onto the semiconductor fine particles 22, the co-adsorbent exhibits an effect of suppressing the inefficient association of the metal complex dye and an effect of preventing reverse electron transfer from the surface of the semiconductor fine particles to the redox system in the electrolyte. The amount of the co-adsorbent to be used is not particularly limited, and from the viewpoint of exhibiting the above effects effectively, the amount is preferably 1 to 200 moles, more preferably 10 to 150 moles, and particularly preferably 20 to 50 moles, with respect to 1 mole of the metal complex dye.

### <Charge Transfer Layer>

The charge transfer layers 3 and 47 used in the photoelectric conversion element of the present invention are layers having a function of complementing electrons for the oxidized forms of the dye 21, and are provided between the light-receiving electrode 5 or 40 and the counter electrode 4 or 48.

The charge transfer layers 3 and 47 include electrolytes. Here, the expression, "the charge transfer layer includes an electrolyte", is used to inclusion of both of an aspect in which the charge transfer layer consists of only electrolytes and an aspect in which the charge transfer layer consists of electrolytes and materials other than the electrolytes.

The charge transfer layers 3 and 47 may be any of a solid form, a liquid form, a gel form, or a mixture thereof.

### - Electrolyte -

Examples of the electrolyte include a liquid electrolyte having a redox pair dissolved in an organic solvent, and a so-called gel electrolyte in which a molten salt containing a redox pair and a liquid having a redox pair dissolved in an organic solvent are impregnated in a polymer matrix. Among those, from the viewpoint of photoelectric conversion efficiency, a liquid electrolyte is preferable.

Examples of the redox pair include a combination of iodine and an iodide (preferably an iodide salt or an iodide ionic liquid, and preferably lithium iodide, tetrabutylammonium iodide, tetrapropylammonium iodide, and methylpropylimidazolium iodide), a combination of an alkylviologen (for example, methylviologen chloride, hexylviologen bromide, and benzylviologen tetrafluoroborate) and a reductant thereof, a combination of a polyhydroxybenzene (for example, hydroquinone and naphthohydroquinone) and an oxidized form thereof, a combination of a divalent iron complex and a trivalent iron complex (for example, a combination of potassium ferricyanide and potassium ferrocyanide), and a combination of a divalent cobalt complex and a trivalent cobalt complex. Among these, a combination of iodine and an iodide, or a combination of a divalent cobalt complex and a trivalent cobalt complex is preferable, and a combination of iodine and an iodide is particularly preferable.

As the cobalt complex, the complex represented by Formula (CC) described in paragraph Nos. 0144 to 0156 of JP2014-82189A is preferable, and the description of paragraph Nos. 0144 to 0156 of JP2014-82189A is preferably incorporated in the present specification.

In a case where a combination of iodine and iodide is used as an electrolyte, it is preferable that a nitrogen-containing aromatic cation iodine salt as a 5- or 6-membered ring is additionally used.

The organic solvent which is used in a liquid electrolyte and a gel electrolyte is not particularly limited, but is preferably an aprotic polar solvent (for example, acetonitrile, propylene carbonate, ethylene carbonate, dimethylformamide, dimethylsulfoxide, sulfolane, 1,3-dimethylimidazolinone, and 3-methyloxazolidinone).

In particular, as the organic solvent which is used for a liquid electrolyte, a nitrile compound, an ether compound, an ester compound, or the like is preferable, a nitrile compound is more preferable, and acetonitrile or methoxypropionitrile is particularly preferable.

With regard to the molten salt or the gel electrolyte, those described in paragraph No. 0205 and paragraph Nos. 0208 to 0213 of JP2014-139931A are preferable, and the descriptions of paragraph No. 0205 and paragraph Nos. 0208 to 0213 of JP2014-139931A are preferably incorporated herein by reference.

The electrolyte may contain aminopyridine compounds, benzimidazole compounds, aminotriazole compounds, aminothiazole compounds, imidazole compounds, aminotriazine compounds, urea compounds, amide compounds, pyrimidine compounds, and heterocycles not including nitrogen, in addition to pyridine compounds such as 4-t-butylpyridine, as an additive.

Moreover, a method of controlling the moisture content of the electrolytic solution may be employed in order to enhance the photoelectric conversion efficiency. Preferred examples of the method of controlling the moisture content include a method of controlling the concentration, and a method of adding a dehydrating agent. The moisture content of the electrolytic solution is preferably adjusted to 0% to 0.1% by mass.

Iodine can also be used as a clathrate compound of iodine with cyclodextrin. Furthermore, a cyclic amidine may be used, or an antioxidant, a hydrolysis inhibitor, a decomposition inhibitor, or zinc iodide may be added.

A solid-state charge transport layer such as a p-type semiconductor or a hole transport material, for example, CuI or CuNCS, may be used in place of the liquid electrolyte and the quasi-so lid-state electrolyte as described above. Moreover, the electrolytes described in Nature, vol. 486, p. 487 (2012) and the like may also be used. For a solid-state charge transport layer, an organic hole transport material may be used. As the organic hole transport material, those described in paragraph No. 0214 of JP2014-139931A are preferable, and the description in paragraph No. 0214 of JP2014-139931A are preferably incorporated as it is herein by reference.

The redox pair serves as an electron carrier, and accordingly, it is preferably contained at a certain concentration. The concentration of the redox pair in total is preferably 0.01 mol/L or more, more preferably 0.1 mol/L or more, and particularly preferably 0.3 mol/L or more. In this case, the upper limit is not particularly limited, but is usually approximately 5 mol/L.

### <Counter Electrode>

The counter electrodes 4 and 48 preferably work as a positive electrode in a dye-sensitized solar cell. The counter electrodes 4 and 48 usually have the same configurations as the electrically conductive support 1 or 41, but in a configuration in which strength is sufficiently maintained, a substrate 44 is not necessarily required. A preferred structure of the counter electrodes 4 and 48 is a structure having a high charge collecting effect. At least one of the electrically conductive support 1 or 41 and the counter electrode 4 or 48 should be substantially transparent so that light may reach the photoconductor layers 2 and 42. In the dye-sensitized solar cell of the present invention, the electrically conductive support 1 or 41 is preferably transparent to allow sunlight to be incident from the side of the electrically conductive support 1 or 41. In this case, the counter electrodes 4 and 48 more preferably have light reflecting properties. As the counter electrodes 4 and 48 of the dye-sensitized solar cell, glass or plastics on which a metal or an electrically conductive oxide is deposited is preferable, and glass on which platinum is deposited is particularly preferable. In the dye-sensitized solar cell, a lateral side of the cell is preferably sealed with a polymer, an adhesive, or the like in order to prevent evaporation of components.

### [Method for Producing Photoelectric Conversion Element and Dye-Sensitized Solar Cell]

The photoelectric conversion element and the dye-sensitized solar cell of the present invention are preferably produced using a dye solution (the dye solution of the present invention) which contains the metal complex dye of the present invention and a solvent.

Such a dye solution is formed of the metal complex dye of the present invention dissolved in a solvent, and may also include other components such as the co-adsorbent, if necessary.

Examples of the solvent to be used include the solvents described in JP2001-291534A, but are not particularly limited thereto. In the present invention, an organic solvent is preferable, and an alcohol solvent, an amide solvent, a nitrile solvent, a ketone solvent, a hydrocarbon solvent, and a mixed solvent of two or more kinds of these solvents are more preferable. As the mixed solvent, a mixed solvent of an alcohol solvent and a solvent selected from an amide solvent, a nitrile solvent, a ketone solvent, and a hydrocarbon solvent is preferable; a mixed solvent of an alcohol solvent and an amide solvent, a mixed solvent of an alcohol solvent and a hydrocarbon solvent, and a mixed solvent of an alcohol solvent and a nitrile solvent are more preferable; and a mixed solvent of an alcohol solvent and an amide solvent, and a mixed solvent of an alcohol solvent and a nitrile solvent are particularly preferable. Specifically, a mixed solvent of at least one of methanol, ethanol, propanol, or butanol, and at least one of dimethylformamide or dimethylacetamide, and a mixed solvent of at least one of methanol, ethanol, propanol, or t-butanol, and acetonitrile are preferable.

The dye solution preferably contains a co-adsorbent, and as the co-adsorbent, the aforementioned co-adsorbent is preferable.

Here, the dye solution of the present invention is preferably one in which the concentrations of the metal complex dye and the co-adsorbent have been adjusted so that the dye solution can be used as it is during production of the photoelectric conversion element or the dye-sensitized solar cell. In the present invention, the dye solution of the present invention preferably contains 0.001% to 0.1% by mass of the metal complex dye of the present invention. The amount of the co-adsorbent to be used is as described above.

For the dye solution, it is preferable to adjust the moisture content, and thus in the present invention, the water content is preferably adjusted to 0% to 0.1% by mass.

In the present invention, it is preferable to manufacture a photoconductor layer by making the metal complex dye represented by Formula (1) or a dye including the same on the surface of the semiconductor fine particles, using the dye solution. That is, the photoconductor layer is preferably formed by applying (including a dip method) the dye solution onto the semiconductor fine particles provided on the electrically conductive support, followed by drying and curing.

By further providing a charge transfer layer, a counter electrode, or the like for a light-receiving electrode including the photoconductor layer as manufactured above, the photoelectric conversion element of the present invention can be obtained.

The dye-sensitized solar cell is produced by connecting an external circuit 6 with the electrically conductive support 1 and the counter electrode 4 of the photoelectric conversion element thus manufactured.

### EXAMPLES

The present invention will be described below in more detail, based on Examples, but the present invention is not limited thereto.

Hereinafter, a method for synthesizing the metal complex dye of the present invention will be described in detail.

In the following synthesis method, the room temperature means 25°C. Further, in the following schemes or chemical formulae, Et represents ethyl, Bu represents butyl, and TBA represents tetrabutylammonium.

The metal complex dye and the synthesis intermediate synthesized in Example 1 were identified by mass spectrum (MS) measurement and ¹H-NMR measurement.

### Example 1 (Synthesis of Metal Complex Dyes)

Metal complex dyes (D-1) to (D-23) synthesized in the present Example are shown below.

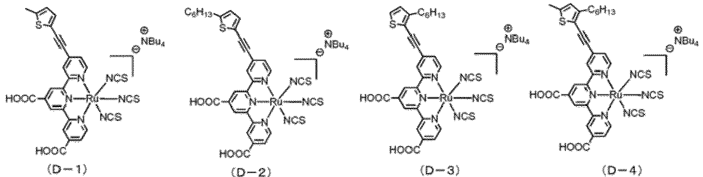

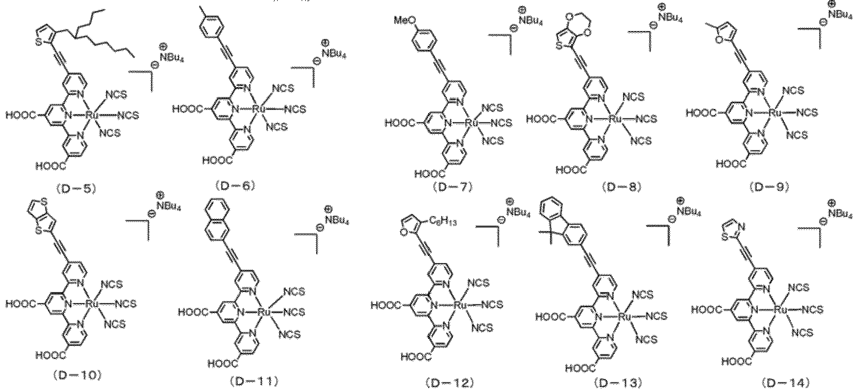

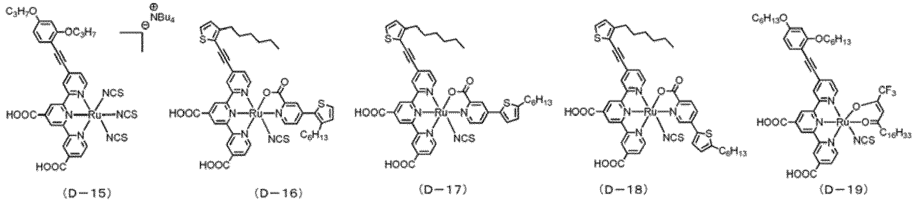

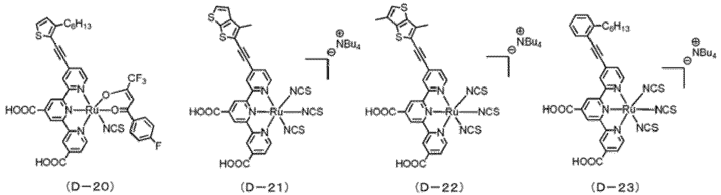

Hereinafter, a method for synthesizing the metal complex dye of the present invention will be described in detail, but the starting materials, the dye intermediates, and the synthesis routes are not limited thereto.

### (Synthesis of Metal Complex Dye (D-1))

According to the following scheme, a metal complex dye (D-1) was synthesized.

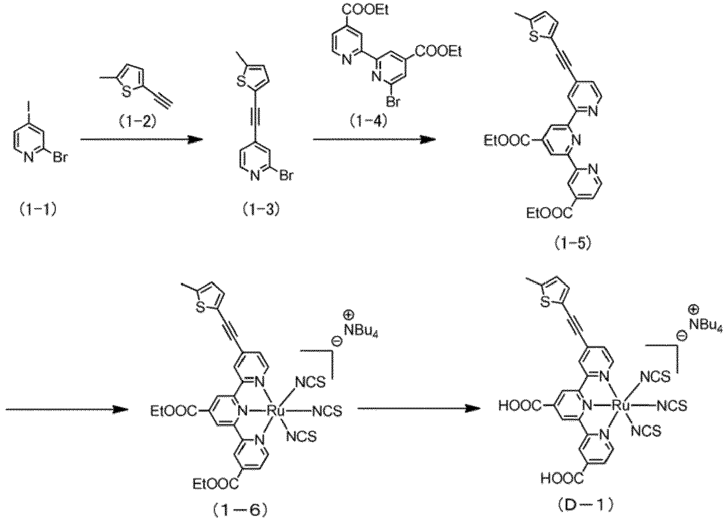

### (i) Synthesis of Compound (1-3)

To a mixture of 3.67 g (12.9 mmol) of a compound (1-1) and 1.63 g (13.3 mmol) of a compound (1-2) was added 52 mL of dimethylformamide (DMF), repeatedly subjected three times to pressure reduction and nitrogen gas substitution, and degassed. 905 mg (1.29 mmol) of bis(triphenylphosphine)dichloropalladium (II), 491 mg (2.58 mmol) of copper (I) iodide, and 13 mL of triethylamine were added thereto, and the mixture was stirred (reacted) at room temperature. After reacting the mixture for 2 hours, a saturated aqueous ammonium chloride solution and ethyl acetate were added to the reaction solution to extract a reaction product. The organic phase was dried over magnesium sulfate, magnesium sulfate was filtered off, and the residue was concentrated. The concentrated residue was purified by silica gel column chromatography. The obtained solid was recrystallized with isopropanol to obtain 2.16 g (yield of 60%) of a compound (1-3).
Identification of Compound (1-3)
MS (ESI⁺) m/z: 280.1 ([M+H]⁺)
Chemical shift σ (ppm) by ¹H-NMR (400 MHz, solvent: CDCl₃, internal standard substance: tetramethylsilane (TMS)): 2.52 (3H, s), 6.71 (1H, d), 7.18 (1H, d), 7.28 (1H, d), 7.55 (1H, s), 8.33 (1H, s)

### (ii) Synthesis of Compound (1-5)

1.41 g (5.06 mmol) of the compound (1-3) was dissolved in 126 mL of toluene, and the obtained solution was repeatedly subjected three times to pressure reduction and nitrogen gas substitution, and degassed. 244 mg (0.211 mmol) of tetrakis(triphenylphosphine)palladium (0) and 1.93 g (5.90 mmol) of hexamethylditin were added thereto, and the mixture was heated and refluxed. After reacting the mixture for 4 hours, the reaction solution was left to be cooled to room temperature, filtered through Celite to remove the insolubles, and further concentrated. To the concentrated residue were added 126 mL of toluene and 1.60 g (4.22 mmol) of the compound (1-4), and the obtained mixture was repeatedly subjected three times to pressure reduction and nitrogen gas substitution, and degassed. 244 mg (0.211 mmol) of tetrakis(triphenylphosphine)palladium (0) was added thereto and the mixture was heated and refluxed. After reacting the mixture for 3 hours, the reaction solution was left to be cooled, filtered through Celite to remove the insolubles, and further concentrated to obtain a crude product. The obtained crude product was purified by silica gel column chromatography, recrystallized with isopropanol to obtain 1.48 g (yield of 70%) of a compound (1-5) which is a diethyl esterified product of a terpyridine compound.
Identification of Compound (1-5)
MS (ESI⁺) m/z: 498.3 ([M+H]⁺)
¹H-NMR (400 MHz, solvent: CDCl₃, internal standard substance: Chemical shift σ (ppm) by tetramethylsilane (TMS)) = 1.48 (6H, m), 2.52 (3H, s), 4.50 (4H, m), 6.72 (1H, d), 7.21 (1H, d), 7.43 (1H, d), 7.94 (1H, d), 8.67 (1H, s), 8.72 (1H, d), 8.90 (1H, d), 9.01 (2H, s), 9.13 (1H, s)

### (iii) Synthesis of Compound (1-6)

1.0 g of the compound (1-5), 0.53 g of ruthenium chloride, and 20 mL of ethanol were put into an eggplant flask, and the mixture was heated and refluxed for 3 hours in a nitrogen atmosphere. The formed precipitates were collected by filtration and washed with ethanol. To the obtained precipitates were added 20 mL of DMF and 4.53 g of tetrabutylammonium thiocyanate, and the mixture was heated at 140°C for 3 hours. The reaction solution was returned to room temperature, and then concentrated, and the concentrated residue was purified by silica gel column chromatography to obtain 0.6 g of a compound (1-6).

### (iv) Synthesis of Metal Complex Dye (D-1)

0.3 g of the compound (1-6), 10 mL of acetone, and 1.45 mL of a 1 M tetrabutylammonium hydroxide (TBAOH) solution in methanol were put into an eggplant flask, and the mixture was heated at 60°C for 2 hours. Thereafter, the mixture was concentrated, 5 mL of water was added thereto, and the mixture was adjusted to pH 3 by the addition of nitric acid (HNO₃). The obtained crystals were as collected by filtration and washed with ultrapure water to obtain 0.25 g of a metal complex dye (D-1).

### (Synthesis of Metal Complex Dye (D-16))

According to the following scheme, a metal complex dye (D-16) and a metal complex dye (D-16TBA) were synthesized.

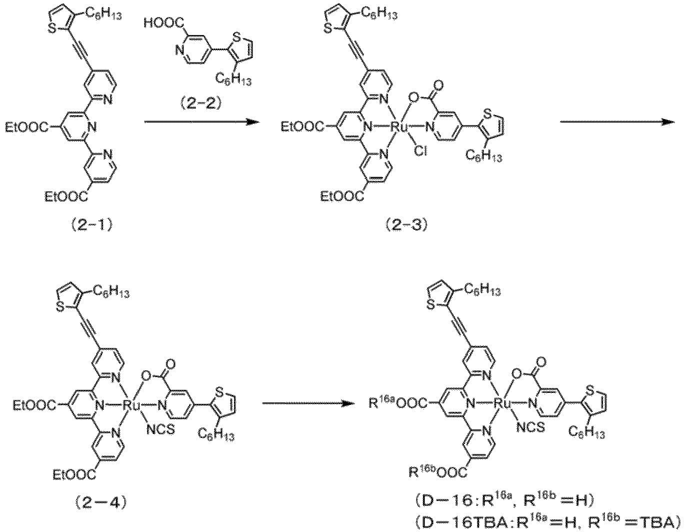

### (i) Synthesis of Compounds (2-1) and (2-2)

A compound (2-1) was synthesized in the same manner as the compound (1-5) in the synthesis of the metal complex dye (D-1).

Furthermore, the compound (2-2) was synthesized in accordance with the synthesis method for the compound No. 45 described in Journal of Medicinal Chemistry, 2011, vol. 54, No. 13, pp. 4721-4734.

### (ii) Synthesis of Compound (2-3)

0.5 g of the compound (2-1), 0.23 g of ruthenium chloride, and 10 mL of ethanol were put into an eggplant flask, and the mixture was heated and refluxed for 3 hours in a nitrogen atmosphere. The obtained precipitates were collected by filtration and washed with ethanol. To the obtained precipitate were added 0.25 g of the compound (2-2), 10 mL of DMF, and 1 mL of tripropylamine and the mixture was heated at 140°C in a nitrogen atmosphere. The reaction mixture was returned to room temperature and then concentrated, and the concentrated residue was purified by silica gel column chromatography to obtain 0.4 g of a compound (2-3).

### (iii) Synthesis of Compound (2-4)

0.4 g of the compound (2-3), 0.3 g of ammonium thiocyanate, 40 mL of DMF, and 4 mL of H₂O were put into an eggplant flask, and the mixture was heated at 100°C. The reaction mixture was returned to room temperature and then concentrated, and the concentrated residue was purified by silica gel column chromatography to obtain 0.3 g of a compound (2-4).

### (iv) Synthesis of Metal Complex Dye (D-16)

300 mg of the compound (2-4), 50 mL of DMF, and 3.1 mL of a 1 N aqueous NaOH solution were put, and the mixture was reacted at room temperature. The obtained solution was adjusted to pH 2.9 by the addition of trifluoromethanesulfonic acid (TfOH). The obtained precipitate was collected by filtration and washed with ultrapure water to obtain 220 mg of a metal complex dye (D-16).

### (V) Synthesis of Metal Complex Dye (D-16TBA)

100 mg of the metal complex dye (D-16) and 0.27 g of a 10% TBAOH solution in methanol were put into a 10-mL eggplant flask, and the mixture was reacted at room temperature. The obtained solution was concentrated to obtain 90 mg of a metal complex dye (D-16TBA). In this metal complex dye (D-16TBA), one of the two carboxyl groups became a salt of TBA. In the scheme, R^{16b} was indicated as the TBA salt for the sake of convenience, but the carboxyl group which becomes the TBA salt is not particularly limited, but any one of R^{16a} and R^{16b} become the TBA salt or a mixture thereof may be the TBA salts.

### (Synthesis of Metal Complex Dyes (D-2) to (D-15) and (D-17) to (D-23))

The metal complex dyes (D-2) to (D-15) and (D-21) to (D-23) were synthesized in the same manner as for the synthesis of the metal complex dye (D-1), respectively.

Furthermore, the metal complex dyes (D-17) to (D-20) and the metal complex dyes (D-17TBA) to (D-20TBA) were synthesized in the same manner as for the synthesis of the metal complex dye (D-16) and the metal complex dye (D-16TBA), respectively.

Each of the synthesized metal complex dyes was confirmed from the date in Table 1 below. Since the synthesized metal complex dyes (D-16TBA) to (D-20TBA) have the same mass as the metal complex dyes (D-16) to (D-20) that are protonated and thus electrically neutral (with the acidic groups becoming carboxyl groups) in the MS measurement, the results of the MS measurements of these TBA salts are omitted.

**[Table 1]**

| Metal complex dye | MS (ESI⁺) |
|---|---|
| D-1 | MS (ESI⁻) m/z: 716.4 ([M]⁻) |
| D-2 | MS (ESI⁻) m/z: 786.6 ([M]⁻) |
| D-3 | MS (ESI⁻) m/z: 786.8 ([M]⁻) |
| D-4 | MS (ESI⁻) m/z: 800.8 ([M]⁻) |
| D-5 | MS (ESI⁻) m/z: 871.1 ([M]⁻) |
| D-6 | MS (ESI⁻) m/z: 710.4 ([M]⁻) |
| D-7 | MS (ESI⁻) m/z: 726.7 ([M]⁻) |
| D-8 | MS (ESI⁻) m/z: 760.7 ([M]⁻) |
| D-9 | MS (ESI⁻) m/z: 700.5 ([M]⁻) |
| D-10 | MS (ESI⁻) m/z: 758.7 ([M]⁻) |
| D-11 | MS (ESI⁻) m/z: 746.3 ([M]⁻) |
| D-12 | MS (ESI⁻) m/z: 770.8 ([M]⁻) |
| D-13 | MS (ESI⁻) m/z: 812.9 ([M]⁻) |
| D-14 | MS (ESI⁻) m/z: 703.7 ([M]⁻) |
| D-15 | MS (ESI⁻) m/z: 812.9 ([M]⁻) |
| D-16 | MS (ESI⁺) m/z: 960.3 ([M+H]⁺) |
| D-17 | MS (ESI⁺) m/z: 960.5 ([M+H]⁺) |
| D-18 | MS (ESI⁺) m/z: 960.3 ([M+H]⁺) |
| D-19 | MS (ESI⁺) m/z: 1145.8 ([M+H]⁺) |
| D-20 | MS (ESI⁺) m/z: 904.9 ([M+H]⁺) |
| D-21 | MS (ESI⁻) m/z: 772.7 ([M]⁻) |
| D-22 | MS (ESI⁻) m/z: 786.9 ([M]⁻) |
| D-23 | MS (ESI⁻) m/z: 780.8 ([M]⁻) |

### Example 2 (Production of Dye-Sensitized Solar Cell)

Using the metal complex dye synthesized in Example 1 or each of the following comparative compounds (C1) to (C3), a dye-sensitized solar cell 20 (in a dimension of 5 mm × 5 mm) shown in Fig. 2 was produced and the following performance was evaluated according to the procedure shown below. The results are shown in Table 2.

### (Manufacture of Light-Receiving Electrode Precursor A)

An electrically conductive support 41 was prepared in which a fluorine-doped SnO₂ electrically-conductive film (transparent electrically-conductive film 43, film thickness; 500 nm) was formed on a glass substrate (substrate 44, thickness of 4 mm). Further, a titania paste "18NR-T" (manufactured by DyeSol) was screen-printed on the SnO₂ electrically-conductive film, followed by drying at 120°C. Then, the dried titania paste "18NR-T" was screen-printed again, followed by drying at 120°C for 1 hour. Thereafter, the dried titania paste was calcined at 500°C to form a semiconductor layer 45 (film thickness; 10 µm). A titania paste "18NR-AO" (manufactured by DyeSol) was screen-printed on the semiconductor layer 45, followed by drying at 120°C for 1 hour. Then, the dried titania paste was calcined at 500°C to form a light-scattering layer 46 (film thickness; 5 µm) on the semiconductor layer 45. Thus, a photoconductor layer 42 (the area of the light-receiving surface; 5 mm × 5 mm, film thickness; 15 µm, a metal complex dye being not carried) was formed on the SnO₂ electrically-conductive film, thereby manufacturing a light-receiving electrode precursor A not carrying a metal complex dye.

### (Manufacture of Light-Receiving Electrode Precursor B)

An electrically conductive support 41 was prepared in which a fluorine-doped SnO₂ electrically-conductive film (transparent electrically-conductive film 43, film thickness; 500 nm) was formed on a glass substrate (substrate 44, thickness of 4 mm). Further, a titania paste "18NR-T" (manufactured by DyeSol) was screen-printed on the SnO₂ electrically-conductive film, followed by drying at 120°C. Then, the dried titania paste was calcined at 500°C to form a semiconductor layer 45 (the area of the light-receiving surface; 5 mm × 5 mm, film thickness; 6 µm, a metal complex dye being not carried). Thus, a photoconductor layer 42 (the area of the light-receiving surface; 5 mm × 5 mm, film thickness; 6 µm, a metal complex dye being not carried) was formed on the SnO₂ electrically-conductive film, thereby manufacturing a light-receiving electrode precursor B not carrying a metal complex dye.

### (Adsorption of Dye)

Next, each of the metal complex dyes ((D-1) to (D-23) and metal complex dyes (D-16TBA) to (D-20TBA)) synthesized in Example 1 was carried onto the photoconductor layer 42 not carrying a metal complex dye as described below. First, each of the metal complex dyes was dissolved in a mixed solvent of t-butanol and acetonitrile at 1:1 (volume ratio) such that the concentration was 2 × 10⁻⁴ mol/L. Further, 30 mol of deoxycholic acid as a co-adsorbent was added to one mol of the metal complex dye, thereby preparing each of dye solutions. Next, the light-receiving electrode precursor A was immersed in each of the dye solutions at 25°C for 20 hours, and dried after pulling out from the dye solution, thereby manufacturing each of light-receiving electrodes 40 having the respective metal complex dyes carried on the light-receiving electrode precursor A.

Each of the metal complex dyes was similarly carried onto the light-receiving electrode precursor B to manufacture each of light-receiving electrodes 40 having the respective metal complex dyes carried on the light-receiving electrode precursor B.

### (Assembly of Dye-Sensitized Solar Cell)

Then, a platinum electrode (thickness of a Pt thin film; 100 nm) having the same shape and size as that of the electrically conductive support 41 was manufactured as a counter electrode 48. Further, 0.1 M (mol/L) of iodine, 0.1 M of lithium iodide, 0.5 M of 4-t-butylpyridine, and 0.6 M of 1,2-dimethyl-3-propylimidazolium iodide were dissolved in acetonitrile to manufacture a liquid electrolyte as an electrolytic solution. In addition, a Spacer S (trade name: "SURLYN") manufactured by DuPont, which has a shape matching to the size of the photoconductor layer 42, was prepared.

Each of the light-receiving electrodes 40 manufactured as above and the counter electrode 48 were arranged to face each other through the Spacer S and thermally compressed, and then the liquid electrolyte was filled from the inlet for the electrolytic solution between the photoconductor layer 42 and the counter electrode 48, thereby forming a charge transfer layer 47. The outer periphery and the inlet for the electrolytic solution of thus manufactured cell were sealed and cured using RESIN XNR-5516 manufactured by Nagase ChemteX Corporation, thereby producing each of dye-sensitized solar cells (Sample Nos. 1 to 23).

Each of the dye-sensitized solar cells with the Sample Nos. 1 to 15 and 21 to 23 produced as above includes two kinds of the dye-sensitized solar cells produced using the light-receiving electrode precursor A ("A" attached to the Sample No. in some cases) and the dye-sensitized solar cells produced using the light-receiving electrode precursor B ("B" attached to the Sample No. in some cases).

Furthermore, the dye-sensitized solar cells of the Sample Nos. 16 to 20 includes the dye-sensitized solar cells using the metal complex dyes (D-16 to D-20) which are electrically neutral, and the dye-sensitized solar cells using the metal complex dyes (D-16TBA to D-20TBA) of the TBA salts, and there are four kinds in total, each further including the dye-sensitized solar cells using the light-receiving electrode precursor A and the dye-sensitized solar cells using the light-receiving electrode precursor B.

Comparative dye-sensitized solar cells (Sample Nos. c1 to c3) were produced in the same manner as for the production of the dye-sensitized solar cells, except that each of the following comparative metal complex dyes (C1) to (C3) was used instead of the metal complex dye synthesized in Example 1 in the production of the dye-sensitized solar cell.

The metal complex dye (C1) is the dye (Compound 1) described in Examples of US2009/0107552A. The metal complex dye (C2) was synthesized in accordance with the synthesis method for the metal complex dye. The metal complex dye (C3) is the dye described in [0042] of JP2012-36237A.

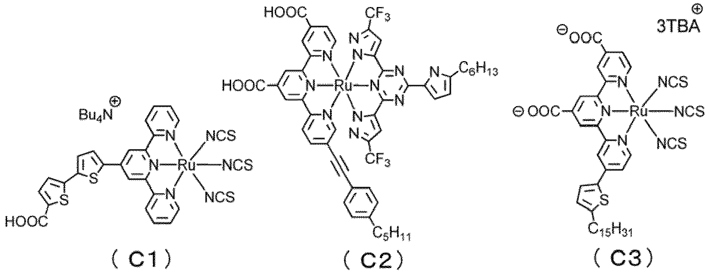

### <Evaluation of Photoelectric Conversion Efficiency>

The cell characteristic test was carried out using each of the produced dye-sensitized solar cells. The cell characteristic test was carried out by the irradiation with artificial sunlight of 1,000 W/m² from a xenon lamp through an AM 1.5 filter, using a solar simulator (WXS-85H manufactured by WACOM). The current-voltage characteristics were measured using an I-V tester to determine the photoelectric conversion efficiency.

### (Conversion Efficiency (A))

For each of the dye-sensitized solar cells (Sample Nos. 1A to 23A and c1A to c3A) produced using the light-receiving electrode precursors A in the dye-sensitized solar cells with the respective Sample Nos., the photoelectric conversion efficiency (referred to as conversion efficiency (A)) determined as above was evaluated according to the following criteria in comparison with that of the conversion efficiency (A_{c1A}) of the comparative dye-sensitized solar cell (Sample No. c1A).

For evaluation of the conversion efficiency (A), A and B are the acceptable levels in the present test, with A being preferable.

The conversion efficiency (A) was evaluated according to the following criteria in comparison with that of the conversion efficiency (A_{c1A}).
A: More than 1.2 times
B: More than 1.1 times and 1.2 times or less
C: More than 1.0 time and 1.1 times or less
D: 1.0 Time or less

### (Conversion Efficiency (B))

For each of the dye-sensitized solar cell (Sample Nos. 1B to 23B and c1B to c3B) produced using the light-receiving electrode precursors B in the dye-sensitized solar cells with the respective Sample Nos., each photoelectric conversion efficiency (referred to as conversion efficiency (B)) was determined in the same manner as for the conversion efficiency (A).

The determined conversion efficiency (B) was evaluated according to the following criteria in comparison with that of the conversion efficiency (A_{c1A}) of the comparative dye-sensitized solar cell (Sample No. c1A).

For evaluation of the conversion efficiency (B), S, A, and B are the acceptable levels of the present test, with S and A being preferable.

The conversion efficiency (B) was evaluated as follows in comparison with that of the conversion efficiency (A_{c1A}).
S: More than 1.1 times
A: More than 1.0 time and 1.1 times or less
B: More than 0.9 times and 1.0 time or less
C: 0.9 Times or less

**[Table 2]**

| Sample Nos. | Metal complex dye | Conversion efficiency (A) | Conversion efficiency (B) | Note |
|---|---|---|---|---|
| 1 | D-1 | B | A | Present invention |
| 2 | D-2 | B | A | Present invention |
| 3 | D-3 | A | S | Present invention |
| 4 | D-4 | A | S | Present invention |
| 5 | D-5 | A | S | Present invention |
| 6 | D-6 | B | A | Present invention |
| 7 | D-7 | B | A | Present invention |
| 8 | D-8 | B | A | Present invention |
| 9 | D-9 | B | A | Present invention |
| 10 | D-10 | B | A | Present invention |
| 11 | D-11 | B | A | Present invention |
| 12 | D-12 | A | S | Present invention |
| 13 | D-13 | B | A | Present invention |
| 14 | D-14 | B | A | Present invention |
| 15 | D-15 | A | S | Present invention |
| 16 | D-16 | A | S | Present invention |
| | D-16TBA | A | S | Present invention |
| 17 | D-17 | A | S | Present invention |
| | D-17TBA | A | S | Present invention |
| 18 | D-18 | A | S | Present invention |
| | D-18TBA | A | S | Present invention |
| 19 | D-19 | A | S | Present invention |
| | D-19TBA | A | S | Present invention |
| 20 | D-20 | A | S | Present invention |
| | D-20TBA | A | S | Present invention |
| 21 | D-21 | B | A | Present invention |
| 22 | D-22 | B | A | Present invention |
| 23 | D-23 | A | S | Present invention |
| c1 | c-1 | D | C | Comparative Example |
| c2 | c-2 | C | C | Comparative Example |
| c3 | c-3 | C | C | Comparative Example |

As seen from the results of Table 2, the following findings can be noted.

All of the photoelectric conversion elements and the dye-sensitized solar cells of the present invention (Sample Nos. 1 to 23), in which the metal complex dye represented by Formula (1) using a combination of the tridentate ligand LA represented by Formula (AL-1) and the ligand Z was carried on the semiconductor fine particles, had high conversion efficiency (A) and conversion efficiency (B). Accordingly, it could be seen that by using a combination of the ligand LA and the ligand Z as a ligand of the metal complex dye, the photoelectric conversion elements and the dye-sensitized solar cells have a small effect of the film thickness of the semiconductor layer and exhibit excellent photoelectric conversion efficiency, for example, even when they are thin with a thickness of up to 6 µm. The metal complex dye of the present invention provided the same results even when they are electrically neutral or they are TBA salts.

Furthermore, if R^{V3} in Formula (AL-1) has an alkyl group or alkoxy group having 3 or more carbon atoms on a specific sp² carbon atom of a monocycle bonded to the ethynylene group in Formula (AL-1), the effect of improving the conversion efficiency (A) and the conversion efficiency (B) is enhanced.

Moreover, the metal complex dye of the present invention, having the ligand LA and the ligand Z, could be suitably used as a sensitizing dye of the photoelectric conversion element and the dye-sensitized solar cell of the present invention. In addition, the dye solution of the present invention, containing a metal complex dye having the ligand LA and the ligand Z, and a solvent, can be suitably used for the preparation of semiconductor fine particles carrying the metal complex dye of the present invention.

To contrary, the comparative photoelectric conversion elements and dye-sensitized solar cells (Sample Nos. c1 to c3), in which the metal complex dyes not using a combination of the ligand LA and the ligand Z were carried on semiconductor fine particles were not sufficient in the conversion efficiency (A) and the conversion efficiency (B). Specifically, the metal complex dyes c1 and c3 having the ligand Z and not having the ligand LA had low conversion efficiency (A) and conversion efficiency (B). In addition, the metal complex dye c2 not having any of the ligand LA and the ligand Z had low conversion efficiency (A) and conversion efficiency (B).

Although the present invention has been described with reference to embodiments, it is not intended that the present invention is not limited by any of the details of the description unless otherwise specified, but should rather be construed broadly within the spirit and scope of the present invention as set out in the accompanying claims.

The present application claims the priority based on JP2015-046442 filed on March 9, 2015, the contents of which are incorporated by reference into a part described herein.

### EXPLANATION OF REFERENCES

1, 41 Electrically conductive support
2, 42 Photoconductor layer
21 Dye
22 Semiconductor fine particles
3, 47 Charge transfer layer
4, 48 Counter electrode
5, 40 Light-receiving electrode
6 Circuit
10 Photoelectric conversion element
100 System in which photoelectric conversion element is applied to cell uses
M Operating means (for example, electric motor)
20 Dye-sensitized solar cell
43 Transparent electrically-conductive film
44 Substrate
45 Semiconductor layer
46 Light-scattering layer
S Spacer

## Claims

1. A photoelectric conversion element comprising:
an electrically conductive support;
a photoconductor layer including an electrolyte;
a charge transfer layer including an electrolyte; and
a counter electrode,
wherein the photoconductor layer has semiconductor fine particles carrying a metal complex dye represented by Formula (1),
Formula (1) M(LA)(Z)_{nZ}·CI_{mY}
in Formula (1),
M represents a metal ion, and
LA represents a tridentate ligand represented by Formula (AL-1), 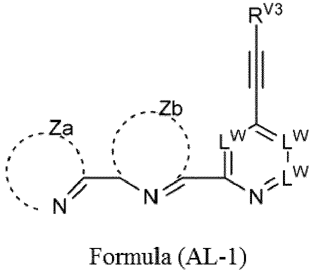
in the formula, Za and Zb each independently represent a non-metal atomic group necessary for completing a 5- or 6-membered ring, in which at least one of rings formed by Za and Zb, respectively, has one or more acidic groups, L^{W}'s each independently represent a nitrogen atom or CR^{W}, R^{W} represents a hydrogen atom or a substituent, and R^{V3} represents an aryl group or a heteroaryl group,
Z represents a ligand selected from the group consisting of an acyloxy group, an acylthio group, a thioacyloxy group, a thioacylthio group, an acylaminooxy group, a thiocarbamate group, a dithiocarbamate group, a thiocarbonate group, a dithiocarbonate group, a trithiocarbonate group, an acyl group, a thiocyanate group, an isothiocyanate group, a cyanate group, an isocyanate group, a selenocyanate group, an isoselenocyanate group, a cyano group, an isocyano group, an alkylthio group, an arylthio group, an alkoxy group, an aryloxy group, a halogen atom, carbonyl, dialkylketone, 1,3-diketone, carbonamide, thiocarbonamide, and thiourea, and nZ represents 2 or 3, and
CI represents a counterion in a case where the counterion is necessary for neutralizing the charge, and mY represents an integer of 0 to 3.

2. The photoelectric conversion element according to claim 1,
wherein the ring formed by Za is at least one selected from the group consisting of a pyridine ring, a pyrimidine ring, a pyrazine ring, a pyridazine ring, a triazine ring, a tetrazine ring, a quinoline ring, an isoquinoline ring, a pyrazole ring, an imidazole ring, a triazole ring, a thiazole ring, an oxazole ring, a benzimidazole ring, a benzotriazole ring, a benzoxazole ring, and a benzothiazole ring,
the ring formed by Zb is at least one selected from the group consisting of a pyridine ring, a pyrimidine ring, a pyrazine ring, a pyridazine ring, a triazine ring, a tetrazine ring, a quinoline ring, an isoquinoline ring, an imidazole ring, a triazole ring, a thiazole ring, an oxazole ring, a benzimidazole ring, a benzotriazole ring, a benzoxazole ring, and a benzothiazole ring, and
the ring including L^{W} is at least one selected from the group consisting of a pyridine ring, a pyrimidine ring, a pyridazine ring, a triazine ring, a tetrazine ring, and a quinoline ring.

3. The photoelectric conversion element according to claim 1 or 2, wherein LA is a tridentate ligand represented by Formula (AL-2), 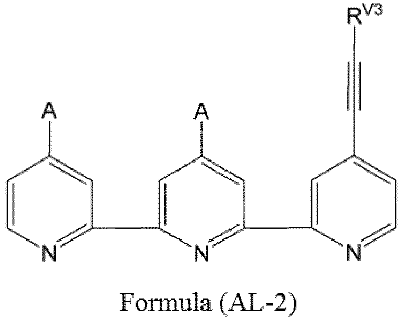 in the formula, A represents an acidic group and R^{V3} has the same definition as R^{V3} in Formula (AL-1).

4. The photoelectric conversion element according to any one of claims 1 to 3, wherein the acidic group is a carboxyl group or a salt thereof.

5. The photoelectric conversion element according to any one of claims 1 to 4,
wherein the aryl group or heteroaryl group of R^{V3} is a monocycle bonded to the ethynylene group in Formula (AL-1) or a polycyclic group containing the monocycle as a fused ring, and in a case where this monocycle is a 5-membered ring, it has a substituent on at least one of sp² carbon atoms at the α-position with respect to the ring-constituting atom bonded to the ethynylene group, and in a case where the monocycle is a 6-membered ring, it has a substituent on at least one of sp² carbon atoms at the α-position and the β-position with respect to the ring-constituting atom bonded to the ethynylene group.

6. The photoelectric conversion element according to any one of claims 1 to 5,
wherein the aryl group or heteroaryl group of R^{V3} is a group represented by any one of Formulae (V-1) to (V-3), 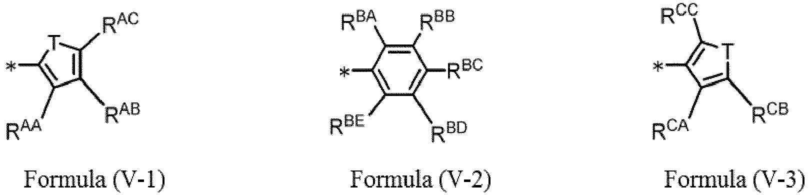
in the formulae, T represents -O-, -S-, -NR^{T}-, -C(R^{T})₂-, or -Si(R^{T})₂-, and R^{T}'s each represent a hydrogen atom or a substituent,
R^{AA} represents a substituent, and R^{AB} and R^{AC} each independently represent a hydrogen atom or a substituent,
R^{BA} to R^{BE} each independently represent a hydrogen atom or a substituent, and at least one of R^{BA}, R^{BB}, R^{BD}, or R^{BE} represents a substituent,
R^{CA} to R^{CC} each independently represent a hydrogen atom or a substituent, and at least one of R^{CA} or R^{CC} represents a substituent, and
* represents a bonding moiety to the ethynylene group in Formula (AL-1).

7. The photoelectric conversion element according to claim 5 or 6,
wherein the substituent is an alkyl group or alkoxy group having 3 to 12 carbon atoms.

8. The photoelectric conversion element according to any one of claims 1 to 7,
wherein Z is a ligand selected from the group consisting of a thiocyanate group, an isothiocyanate group, a halogen atom, a cyano group, a cyanate group, an isocyanate group, an alkylthio group, an arylthio group, an alkoxy group, an aryloxy group, a ligand represented by Formula (XA-1), and a ligand represented by Formula (XA-2), 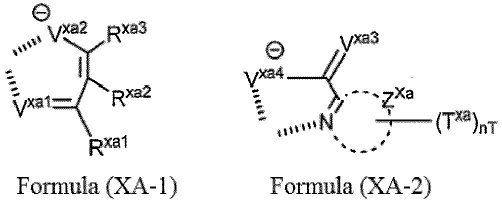 in the formulae, V^{xa1} to V^{xa4} each independently represent a sulfur atom or an oxygen atom, R^{xa1} to R^{xa3} each independently represent a hydrogen atom or a substituent, Z^{Xa} represents a non-metal atomic group necessary for completing a 5- or 6-membered ring, T^{xa} represents a substituent, nT represents an integer of 0 to 4, and the dotted line represents a bonding moiety to the metal ion M.

9. The photoelectric conversion element according to any one of claims 1 to 8,
wherein Z is an isothiocyanate group, a ligand represented by Formula (XA-1b), or a ligand represented by Formula (XA-2b), 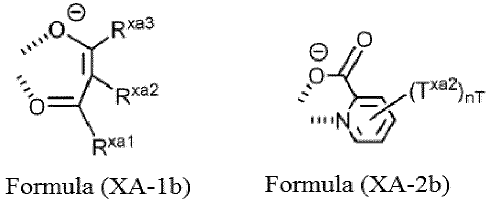 in the formulae, R^{xa1} to R^{xa3} each independently represent a hydrogen atom or a substituent, T^{xa2} represents a substituent, nT represents an integer of 0 to 4, and the dotted line represents a bonding moiety to the metal ion M.

10. The photoelectric conversion element according to any one of claims 1 to 9,
wherein M is Ru²⁺ or Os²⁺.

11. A dye-sensitized solar cell comprising the photoelectric conversion element according to any one of claims 1 to 10.

12. A metal complex dye represented by Formula (1),
Formula (1) M(LA)(Z)_{nZ}·CI_{mY}
in Formula (1),
M represents a metal ion, and
LA represents a tridentate ligand represented by Formula (AL-1), 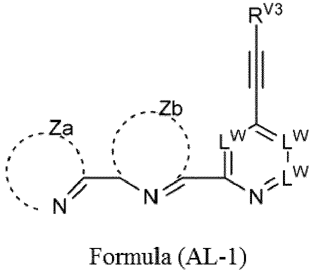
in the formula, Za and Zb each independently represent a non-metal atomic group necessary for completing a 5- or 6-membered ring, in which at least one of rings formed by Za and Zb, respectively, has one or more acidic groups, L^{W}'s each independently represent a nitrogen atom or CR^{W}, and R^{W} represents a hydrogen atom or a substituent, and R^{V3} represents an aryl group or a heteroaryl group,
Z represents a ligand selected from the group consisting of an acyloxy group, an acylthio group, a thioacyloxy group, a thioacylthio group, an acylaminooxy group, a thiocarbamate group, a dithiocarbamate group, a thiocarbonate group, a dithiocarbonate group, a trithiocarbonate group, an acyl group, a thiocyanate group, an isothiocyanate group, a cyanate group, an isocyanate group, a selenocyanate group, an isoselenocyanate group, a cyano group, an isocyano group, an alkylthio group, an arylthio group, an alkoxy group, an aryloxy group, a halogen atom, carbonyl, dialkylketone, 1,3-diketone, carbonamide, thiocarbonamide, and thiourea, and nZ represents 2 or 3, and
CI represents a counterion in a case where the counterion is necessary for neutralizing the charge, and mY represents an integer of 0 to 3.

13. A dye solution comprising the metal complex dye according to claim 12 and a solvent.
